(19) Europäisches Patentamt
European Patent Office
Office européen des brevets

(11) **EP 3 517 987 B1**

(12) **EUROPEAN PATENT SPECIFICATION**

(45) Date of publication and mention
of the grant of the patent:
**28.12.2022 Bulletin 2022/52**

(21) Application number: **18207530.9**

(22) Date of filing: **21.11.2018**

(51) International Patent Classification (IPC):
**G01R 31/392** (2019.01)    **G01R 31/396** (2019.01)
**G01R 31/3835** (2019.01)    **B60L 58/12** (2019.01)
**B60L 58/21** (2019.01)

(52) Cooperative Patent Classification (CPC):
**G01R 31/367; G01R 31/3828; G01R 31/396;
H01M 10/482;** G01R 31/392; Y02E 60/10;
Y02T 10/70

(54) **METHOD AND APPARATUS ESTIMATING A STATE OF BATTERY**

VERFAHREN UND VORRICHTUNG ZUR SCHÄTZUNG EINES ZUSTANDS EINER BATTERIE

PROCÉDÉ ET APPAREIL D'ESTIMATION DE L'ÉTAT D'UNE BATTERIE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **18.12.2017 US 201762599856 P
30.03.2018 KR 20180037674
02.10.2018 KR 20180117812**

(43) Date of publication of application:
**31.07.2019 Bulletin 2019/31**

(73) Proprietor: **Samsung Electronics Co., Ltd.
Gyeonggi-do 16677 (KR)**

(72) Inventors:
• **KIM, Jinho
16678 Gyeonggi-do (KR)**
• **SUNG, Young Hun
16678 Gyeonggi-do (KR)**
• **Song, Tae Won
16678 Gyeonggi-do (KR)**

(74) Representative: **Grünecker Patent- und
Rechtsanwälte
PartG mbB
Leopoldstraße 4
80802 München (DE)**

(56) References cited:
**EP-A1- 3 499 257      US-A1- 2013 207 462
US-A1- 2016 363 632      US-A1- 2017 045 587**

## Description

### BACKGROUND

#### 1. Field

The following description relates to battery state estimation.

#### 2. Description of Related Art

A state of a battery is estimated using various methods. The state of the battery may be estimated by integrating currents of the corresponding batteries or by using a battery model such as, for example, an electrical circuit model or an electrochemical model.
US 2017/045587 A1 discloses battery state of charge (SOC) determination apparatuses and methods, where the battery SOC determination apparatus includes a grouper configured to cluster the cells in the battery pack into the groups based on similarity of the sensing data among the cells, a representative cell selector configured to select the representative cell for the each group, a first SOC estimator configured to estimate the SOC of the representative cell of the each group based on the battery model, and a second SOC estimator configured to determine the SOC of the battery pack based on the SOC of the representative cell of the each group.
EP 3 499 257 A1 discloses a battery state estimation method and apparatus, the method including selecting sensing data of a portion of batteries, transmitting the selected sensing data to at least one estimator among estimators, transmitting sensing data of a remaining portion of the batteries to a remaining estimator among the estimators, and determining state information of the batteries using the estimators.

### SUMMARY

It is the object of the present invention to provide an improved method and apparatus for battery state estimation.
This object is solved by the subject matter of the independent claims. Embodiments are defined by the dependent claims.
This Summary is provided to introduce a selection of concepts in a simplified form that are further described below in the Detailed Description. This Summary is not intended to identify key features or essential features of the claimed subject matter, nor is it intended to be used as an aid in determining the scope of the claimed subject matter.
In one general aspect, a processor-implemented battery state estimation method includes determining state information of plural batteries in each of plural switching periods and outputting state information of the batteries in a last switching period of the switching periods. The determining includes determining, for each switching period, state information of a target battery based on a battery model and sensing data of the target battery, and state information of a non-target battery based on a state variation of the non-target battery. A target battery set in a first switching period of the plural switching periods is set to be a non-target battery in a second switching period of the plural switching periods, and a non-target battery in the first switching period is set to be a target battery in the second switching period of the plural switching periods.
The battery state estimation method may further include updating a relationship set for the batteries based on any one or any combination of voltage values of the plural batteries and the state information of the plural batteries in the last switching period.
The set relationship may indicate an order indicating which of the plural batteries is the target battery in each of the plural switching periods, or which groups are formed by grouping the plural batteries.
The battery state estimation method may further include grouping subsets of the plural batteries into groups and assigning respective battery models to the groups.
The determining of the state information of the target battery may include determining state information of a corresponding target battery in each of the groups in each of the plural switching periods based on the respective battery model assigned to each group and sensing data of the corresponding target battery in each group.
A respective total number of members of each of the groups may be equal or different, and a respective total number of the groups may be less than or equal to a total number of the batteries.
The battery state estimation method may further include regrouping the subsets of batteries in response to a group update event occurring as the state information of the batteries in the last switching period is determined. The group update event may occur based on any one or any combination of any two or more of a preset interval, a travel distance of a vehicle using the plural batteries as a power source, and the determined state information.
The grouping and assigning may include grouping the subsets of the batteries based on any one or any combination of previous state information and voltage values of the batteries.
The previous state information may include any one or any combination of charge state information, health state information, and abnormality state information of the batteries determined before a first switching period of the switching periods.
The determining of the state information of the non-target batteries may include determining the state information of the non-target batteries in respective switching periods by adding the respective state variations to previous state information of the respective non-target batteries in the respective switching periods.

The plural batteries may be respective battery cells, battery modules, or battery packs.

The determining of the state information of the target battery may include determining state information of a different target battery in respective multiple different switching periods of the plural switching periods, the different target battery being a respective non-target battery in other respective switching periods of the plural switching periods.

The battery model may be an electrochemical model.

In another general aspect, an apparatus with battery state estimation includes a processor, to determine state information of plural batteries in each of plural switching periods. The processor is configured to determine, for each switching period, state information of a target battery based on a battery model and sensing data of the target battery, and state information of a non-target battery based on a state variation of the non-target battery, and output state information of the batteries in a last switching period of the switching periods. A target battery set in a first switching period of the plural switching periods is set to be a non-target battery in a second switching period of the plural switching periods, and a non-target battery in the first switching period is set to be a target battery in the second switching period of the plural switching periods.

The processor may be further configured to update a relationship set for the batteries based on any one or any combination of voltage values of the batteries and the state information of the batteries in the last switching period.

The relationship set may indicate an order indicating which of the plural batteries is the target battery in each of the plural switching periods, or which groups are formed by grouping the plural batteries.

The processor may be further configured to group subsets of the plural batteries into groups and assign battery models to the respective groups.

The processor may be further configured to determine state information of a corresponding target battery in each of the groups in the each of the plural switching periods based on the respective battery model assigned to each group and sensing data of the corresponding target battery in each group.

A respective total number of members of each of the groups may be equal or different, and a respective total number of the groups may be less than or equal to a total number of the batteries.

The processor may be further configured to regroup the subsets of the batteries in response to a group update event occurring as the state information of the batteries in the last switching period is determined. The group update event may occur based on any one or any combination of any two or more of a preset interval, a travel distance of a vehicle using the plural batteries as a power source, and the determined state information.

The processor may be further configured to group the subsets of the batteries based on any one or any combination of previous state information and voltage values of the batteries.

The previous state information may include any one or any combination of charge state information, health state information, and abnormality state information of the batteries determined before a first switching period of the switching periods.

The processor may be further configured to determine the state information of the non-target batteries in the respective switching periods by adding the respective state variations to previous state information of the respective non-target batteries in the respective switching periods.

The battery model may be an electrochemical model.

Other features and aspects will be apparent from the following detailed description, the drawings, and the claims.

BRIEF DESCRIPTION OF THE DRAWINGS

FIG. 1 illustrates an example of a battery system.

FIGS. 2 and 3 illustrate examples of using a battery state estimating apparatus to determine state information of batteries in a switching period.

FIG. 4 illustrates an example of using a battery state estimating apparatus to update order of batteries.

FIGS. 5 through 8 illustrate examples of using a battery state estimating apparatus to group batteries.

FIGS. 9A through 10B illustrate examples of using a battery state estimating apparatus to determine state information of batteries in a group.

FIGS. 11A through 11C illustrate examples of a group update of a battery state estimating apparatus.

FIG. 12 illustrates an example of a battery state estimating apparatus.

FIG. 13 illustrates an example of a battery state estimating method.

FIG. 14 illustrates an example of a vehicle.

Throughout the drawings and the detailed description, unless otherwise described or provided, the same drawing reference numerals will be understood to refer to the same elements, features, and structures. The drawings may not be to scale, and the relative size, proportions, and depiction of elements in the drawings may be exaggerated for clarity, illustration, and convenience.

## DETAILED DESCRIPTION

The following detailed description is provided to assist the reader in gaining a comprehensive understanding of the methods, apparatuses, and/or systems described herein. However, various changes, modifications, and equivalents of the methods, apparatuses, and/or systems described herein will be apparent after an understanding of the disclosure of this application. For example, the sequences of operations described herein are merely examples, and are not limited to those set forth herein, but may be changed as will be apparent after an understanding of the disclosure of this application, with the exception of operations necessarily occurring in a certain order. Also, descriptions of features that are known in the art may be omitted for increased clarity and conciseness.

The features described herein may be embodied in different forms, and are not to be construed as being limited to the examples described herein. Rather, the examples described herein have been provided merely to illustrate some of the many possible ways of implementing the methods, apparatuses, and/or systems described herein that will be apparent after an understanding of the disclosure of this application.

Although terms such as "first," "second," and "third" may be used herein to describe various members, components, regions, layers, or sections, these members, components, regions, layers, or sections are not to be limited by these terms. Rather, these terms are only used to distinguish one member, component, region, layer, or section from another member, component, region, layer, or section. Thus, a first member, component, region, layer, or section referred to in examples described herein may also be referred to as a second member, component, region, layer, or section without departing from the teachings of the examples.

The terminology used herein is for describing various examples only, and is not to be used to limit the disclosure. The articles "a," "an," and "the" are intended to include the plural forms as well, unless the context clearly indicates otherwise. The terms "comprises," "includes," and "has" specify the presence of stated features, numbers, operations, members, elements, and/or combinations thereof, but do not preclude the presence or addition of one or more other features, numbers, operations, members, elements, and/or combinations thereof.

The features of the examples described herein may be combined in various ways as will be apparent after an understanding of the disclosure of this application. Further, although the examples described herein have a variety of configurations, other configurations are possible as will be apparent after an understanding of the disclosure of this application.

Unless otherwise defined, all terms including technical and scientific terms used herein have the same meaning as commonly understood by one of ordinary skill in the art to which examples belong in view of the present disclosure. It will be further understood that terms, such as those defined in commonly-used dictionaries, should be interpreted as having a meaning that is consistent with their meaning in the context of the relevant art and the present disclosure, and should not be interpreted in an idealized or overly formal sense unless expressly so defined herein.

When describing the examples with reference to the accompanying drawings, like reference numerals refer to like constituent elements and a repeated description related thereto will be omitted. When it is determined that a detailed description of a known function or configuration makes its understanding unnecessarily ambiguous, it will be omitted too.

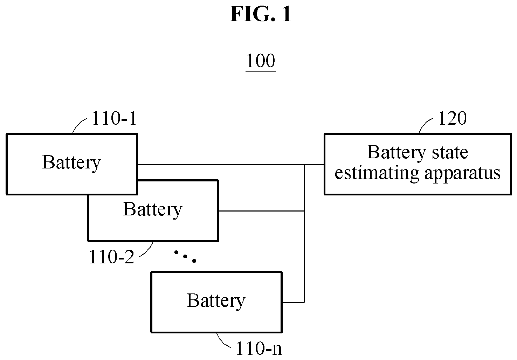

FIG. 1 illustrates an example of a battery system.

Referring to FIG. 1, a battery system 100 includes batteries 110-1 through 110-n and a battery state estimating apparatus 120.

Each of the batteries 110-1 through 110-n may be a battery cell, a battery module or a battery pack.

The battery state estimating apparatus 120 senses the batteries 110-1 through 110-n using at least one sensor. In other words, the battery state estimating apparatus 120 collects sensing data of the batteries 110-1 through 110-n. The sensing data includes, for example, any one or any combination of any two or more of voltage data, current data, and temperature data. However, the sensing data is not limited to the examples mentioned above.

The battery state estimating apparatus 120 sets a relationship for the batteries 110-1 through 110-n. The relationship indicates, for example, an order indicating which battery is a target battery in each of switching periods, or groups formed by grouping the batteries 110-1 through 110-n. For example, the battery state estimating apparatus 120 sets an order of the batteries 110-1 through 110-n or groups the batteries 110-1 through 110-n into groups based on any one or any combination of previous state information and voltage values of the batteries 110-1 through 110-n. The previous state information includes any one or any combination of any two or more of charge state information, for example, states of charge (SOCs), health state information, for example, states of health (SOHs), and abnormality state information of the batteries 110-1 through 110-n determined before a first switching period of the switching periods. The order and the grouping will be described further later.

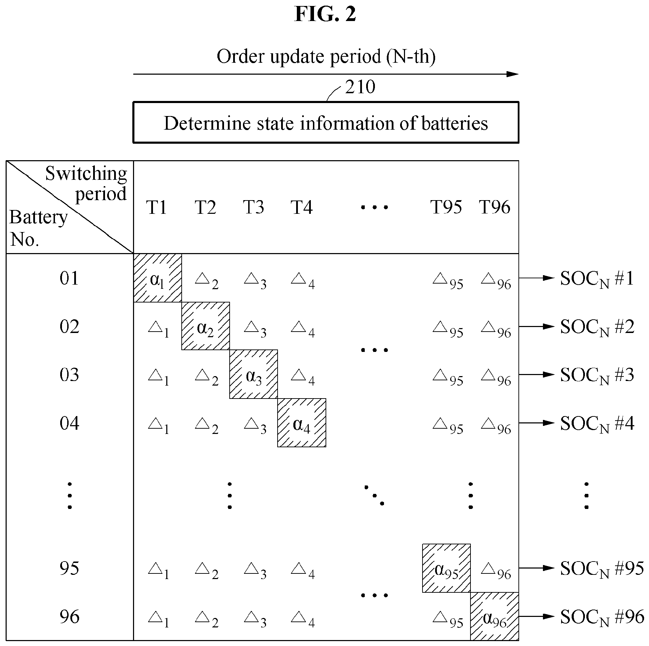

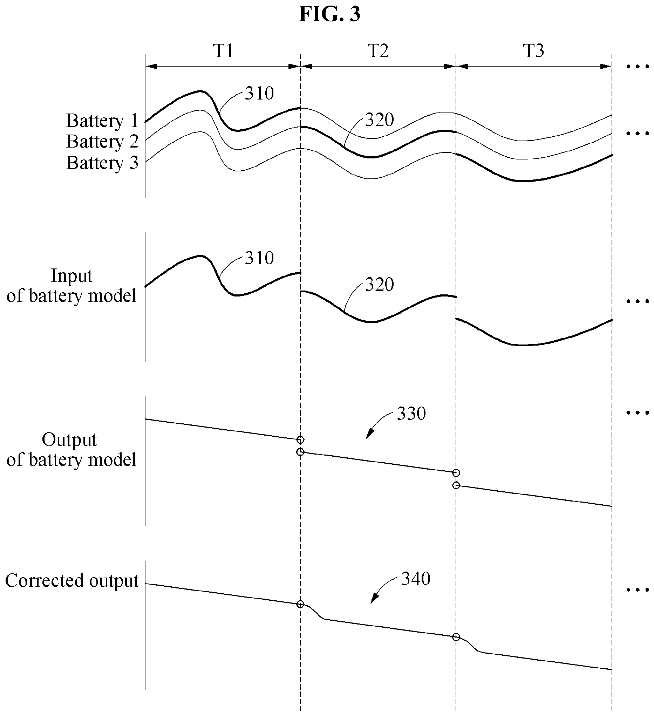

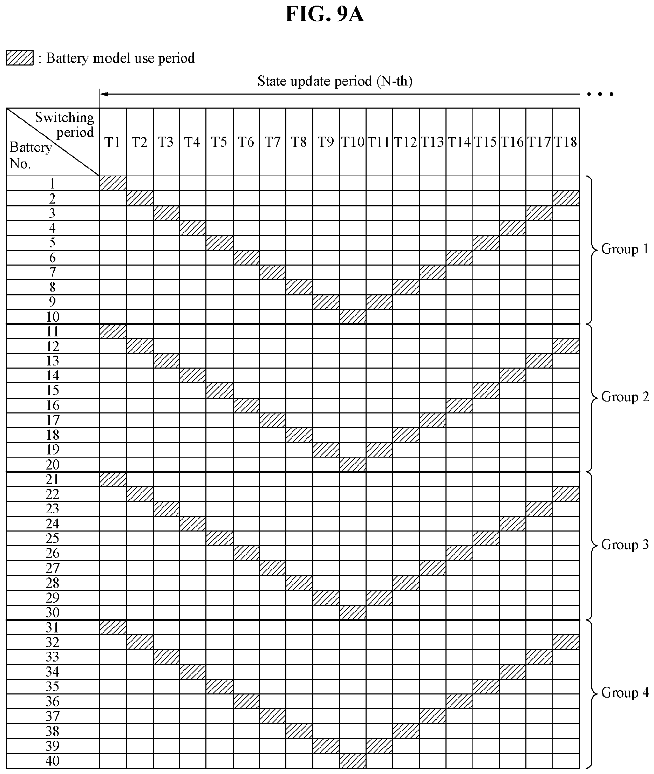

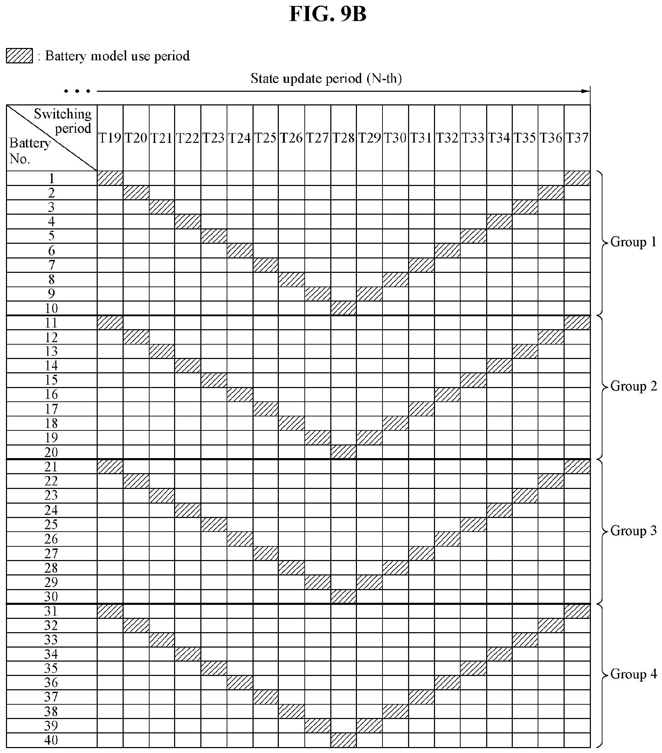

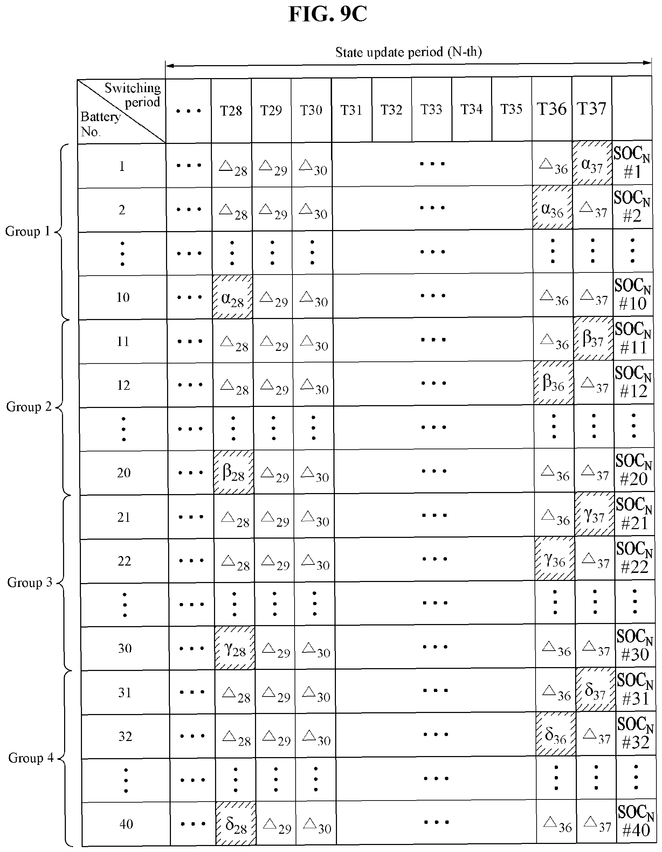

In response to setting the relationship for the batteries 110-1 through 110-n, the battery state estimating apparatus 120 determines state information of the batteries 110-1 through 110-n in each switching period. For example, the battery state estimating apparatus 120 determines state information of a target battery in an individual switching period based on a battery model and sensing data of the target battery, and determines state information of a non-target battery in the individual switching period based on state information in a previous switching period. Further, a detailed description thereof will be provided with reference to FIGS. 2 and 3. In response to the batteries 110-1 through 110-n being divided into groups, the battery state estimating apparatus 120 determines state information of a target battery belonging to each group in the individual switching period based on a battery model assigned to each group and sensing data of the target battery belonging to each group, and determines state information of a non-target battery belonging to each group based on state information in a previous switching period. Further, a detailed description thereof will be provided with reference to FIGS. 9A through 10B.

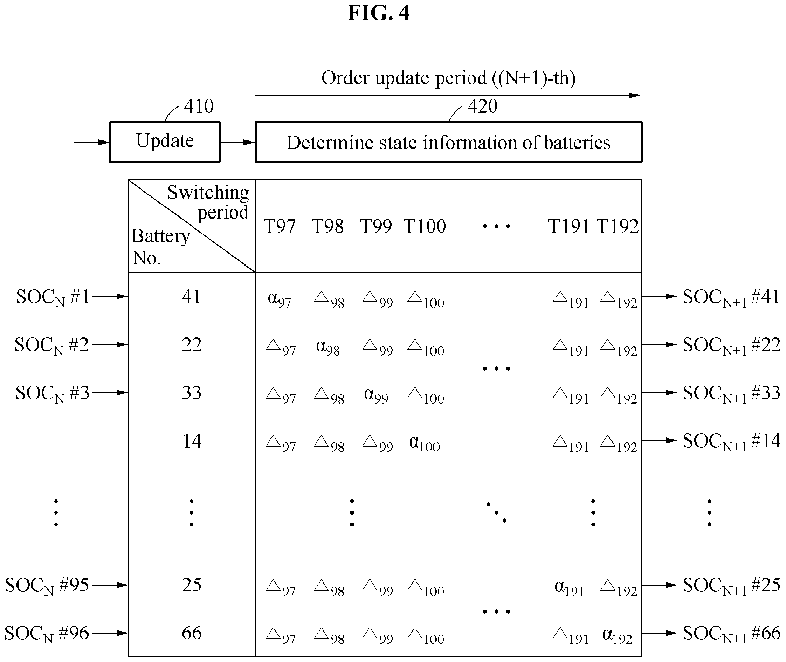

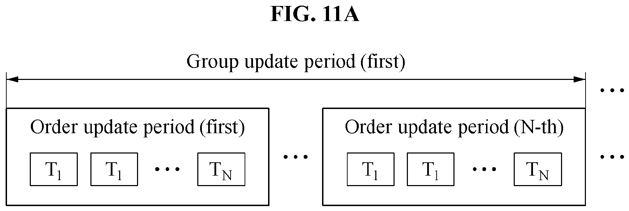

The battery state estimating apparatus 120 updates the relationship set for the batteries 110-1 through 110-n based on any one or any combination of voltage values of the batteries 110-1 through 110-n and state information of the batteries 110-1 through 110-n in the last switching period. The update changes the order of the batteries 110-1 through 110-n. This order update will further be described later with reference to FIG. 4. Further, any one or any combination of members of each group, a number of members of each group, and a number of groups is changed by the update. The group update will further be described later with reference to FIGS. 11A through 11C.

FIGS. 2 and 3 illustrate examples of a battery state estimating apparatus determining state information of batteries in respective switching periods.

Referring to FIG. 2, in operation 210, the battery state estimating apparatus 120 determines state information of the batteries 110-1 through 110-n in each of plural switching periods. In detail, the battery state estimating apparatus 120 determines state information of a target battery in each switching period based on a battery model and sensing data of the target battery in each switching period. An order, to be further described, determines a battery corresponding to the target battery of each switching period. The battery model is, for example, an electrical circuit model or an electrochemical model. However, the battery model is not limited to the examples mentioned above. The battery state estimating apparatus 120 determines state information of a non-target battery in each switching period based on a state variation in each switching period.

In the example of FIG. 2, during an N-th order update period, an order of batteries 1 through 96 is the battery 1, the battery 2, ..., the battery 96. The term "order" with respect to the batteries 1 through 96 means an order that each battery is a target battery in the N-th order update period. The battery 1 is at a first ordinal position in the N-th order update period, and thus is a first target battery among the batteries 1 through 96. That is, the battery 1 corresponds to a target battery in a first switching period T1. The battery 96 is at a last ordinal position in the N-th order update period, and thus is the last target battery. That is, the battery 96 corresponds to a target battery in the last switching period T96.

The order of the batteries 1 through 96 is updated periodically, thus an order update period refers to an interval for updating the order of the batteries 1 through 96.

The battery state estimating apparatus 120 determines state information of the target battery, that is, the battery 1, in the first switching period T1 based on a battery model and sensing data of the battery 1. For example, the battery state estimating apparatus 120 extracts sensing data corresponding to the switching period T1 from the sensing data of the battery 1, and inputs the extracted sensing data into the battery model. The battery model derives the state information of the battery 1 based on the input sensing data.

The battery state estimating apparatus 120 determines state information of non-target batteries, that is, the batteries 2 through 96, in the switching period T1 based on a state variation $\triangle_1$. $\triangle_1$ will be described further later. For example, the battery state estimating apparatus 120 determines state information of the batteries 2 through 96 in the switching period T1 by adding the state variation $\triangle_1$ to state information of the batteries 2 through 96 in an (N-1)-th order update period.

The following Table 1 shows an example of the state information of the batteries 1 through 96 in the switching period T1.

[Table 1]

| Battery | State information |
|---------|-------------------|
| Battery 1 | $\alpha_1$ |
| Battery 2 | $SOC_{N-1}\ \#2 + \triangle_1$ |
| Battery 3 | $SOC_{N-1}\ \#3 + \triangle_1$ |
| Battery 4 | $SOC_{N-1}\ \#4 + \triangle_1$ |
| ... | ... |
| Battery 95 | $SOC_{N-1}\ \#95 + \triangle_1$ |
| Battery 96 | $SOC_{N-1}\ \#96 + \triangle_1$ |

In the above Table 1, $\alpha_1$ denotes a SOC of the battery 1 in the switching period T1, the SOC determined by the battery model, and $SOC_{N-1}\ \#2$, $SOC_{N-1}\ \#3$, ..., and $SOC_{N-1}\ \#96$ denote SOCs of the batteries 2 through 96 in the (N-1)-th order update period, respectively.

In an example, $\triangle_1$ denotes a current-integrated quantity during the switching period T1. The battery state estimating apparatus 120 calculates $\triangle_1$ based on a reference capacity and an amount of currents flowing in a battery pack including the batteries 1 through 96 during the switching period T1. For example, the battery state estimating apparatus 120 calculates $\triangle_1$ using the following Equation 1.

[Equation 1]

$$\Delta_1 = \frac{\int_{t_1}^{t_2} I \, dt}{reference \ capacity}$$

In Equation 1, $t_1$ denotes a start time of a 1st switching period, $t_2$ denotes a finish time of the 1st switching period, and reference capacity is a preset value and denotes a total capacity of a battery of the same type as the batteries 1 through 96. "I" denotes currents flowing in a battery pack.

In the example of FIG. 2, the battery 2 is at a second ordinal position, that is, an ordinal position corresponding to a second target battery. Thus, in the switching period T2, the target battery is switched or changed from the battery 1 to the battery 2. In other words, the battery state estimating apparatus 120 selects the battery 2 as the target battery in the switching period T2, in view of the order. In the switching period T2, the batteries 1, and 3 through 96 correspond to non-target batteries.

The battery state estimating apparatus 120 determines state information of the target battery, that is, the battery 2, in the switching period T2 based on the battery model and sensing data of the battery 2. For example, the battery state estimating apparatus 120 extracts sensing data corresponding to the switching period T2 from the sensing data of the battery 2, and inputs the extracted sensing data into the battery model. The battery model derives the state information of the battery 2 in the switching period T2 from the input sensing data. In this example, the battery state estimating apparatus 120 or the battery model corrects the state information of the battery 2.

Hereinafter, the correction of the state information of the battery 2 will be described with reference to FIG. 3. In the switching period T2, the target battery is switched from the battery 1 to the battery 2, and the battery model receives an input of sensing data 320 of the battery 2, rather than sensing data 310 of the battery 1. That is, there exists a discontinuity between the input data 310 and the input data 320 of the battery model at a switching time. If the battery model derives state information of the battery 2 from the input data 320 and outputs the derived state information in a situation in which such a discontinuity exists, the output of the battery model is discontinuous between T1 and T2, as shown in graph 330. In the example, the battery state estimating apparatus 120 corrects an output of the battery model in each switching period using a separately established correction model or filter, for example, a Kalman filter. As a result, the corrected output is continuous as shown in graph 340. In implementation, a correction function may be built into the battery model, and the output of the battery model may be continuous as shown in the graph 340.

Referring back to FIG. 2, the battery state estimating apparatus 120 determines state information of the non-target batteries, that is, the batteries 1, and 3 through 96, in the switching period T2 based on a state variation $\triangle_2$. For example, the battery state estimating apparatus 120 determines the state information of the batteries 1, and 3 through 96 in the switching period T2 by adding the state variation $\triangle_2$ to the state information of the batteries 1, and 3 through 96 in the switching period T1. The description of $\triangle_1$ applies to $\triangle_2$, and thus, a further detailed description of $\triangle_2$ will be omitted.

The following Table 2 shows an example of the state information of the batteries 1 through 96 in the switching period T2.

[Table 2]

| Battery | State information |
|---------|-------------------|
| Battery 1 | $\alpha_1 + \triangle_2$ |
| Battery 2 | $\alpha_2$ |
| Battery 3 | $SOC_{N-1}$ #3 $+\triangle_1+\triangle_2$ |
| Battery 4 | $SOC_{N-1}$ #4 $+\triangle_1+\triangle_2$ |
| ... | ... |
| Battery 95 | $SOC_{N-1}$ #95 $+\triangle_1+\triangle_2$ |
| Battery 96 | $SOC_{N-1}$ #96 $+\triangle_1+\triangle_2$ |

In the above Table 2, $\alpha_2$ denotes a SOC of the battery 2 in the switching period T2, the SOC determined by the battery model.

With respect to switching periods T3 through T96, the battery state estimating apparatus 120 operates as in the above method.

The following Table 3 shows an example of state information of the batteries 1 through 96 in the last switching period T96.

[Table 3]

| Battery | State information |
|---------|-------------------|
| Battery 1 | $\alpha_1 + \triangle_2 + ... + \triangle_{96}$ |
| Battery 2 | $\alpha_2 + \triangle_3 + ... + \triangle_{96}$ |
| Battery 3 | $\alpha_3 + \triangle_4 + ... + \triangle_{96}$ |
| Battery 4 | $\alpha_4 + \triangle_5 + ... + \triangle_{96}$ |
| ... | ... |
| Battery 95 | $\alpha_{95} + \triangle_{96}$ |
| Battery 96 | $\alpha_{96}$ |

The battery state estimating apparatus 120 operates as described above, thereby quickly and accurately determining state information of the batteries 1 through 96.

For ease of description, the state information of the batteries 1 through 96 for the N-th order update is expressed as shown in the following Table 4.

[Table 4]

| |
|---|
| $SOC_N$ #1=$\alpha_1$+$\triangle_2$+ ...+$\triangle_{96}$ |
| $SOC_N$ #2=$\alpha_2$+$\triangle_3$+ ...+$\triangle_{96}$ |
| $SOC_N$ #3=$\alpha_3$+$\triangle_4$+ ...+$\triangle_{96}$ |
| $SOC_N$ #4=$\alpha_4$+$\triangle_5$+ ...+$\triangle_{96}$ |
| ... |
| $SOC_N$ #95=$\alpha_{95}$+$\triangle_{96}$ |
| $SOC_N$ #96=$\alpha_{96}$ |

FIG. 4 illustrates an example of updating an order of batteries by a battery state estimating apparatus.

Referring to FIG. 4, in operation 410, the battery state estimating apparatus 120 updates an order of the batteries 110-1 through 110-n based on state information of the batteries 110-1 through 110-n in the last switching period of a provided order update period. For example, the battery state estimating apparatus 120 updates or determines the order of the batteries 1 through 96 in ascending order or a descending order of $SOC_N$ #1 through $SOC_N$ #96. That is, the battery state estimating apparatus 120 arranges $SOC_N$ #1 through $SOC_N$ #96 in ascending order or a descending order, and updates or determines the order of the batteries 1 through 96 based on an arrangement result. In another example, the battery state estimating apparatus 120 updates or determines the order of the batteries 1 through 96 in an ascending or descending order of voltage values of the batteries 1 through 96. In the example of FIG. 4, in a case in which a result of arranging $SOC_N$ #1 through $SOC_N$ #96 in a descending order is $SOC_N$ #41 (maximum), $SOC_N$ #22, $SOC_N$ #33, $SOC_N$ #14, ..., $SOC_N$ #25, and $SOC_N$ #66 (minimum), the battery state estimating apparatus 120 updates or determines the order of the batteries 1 through 96 to be 41, 22, 33, 14, ..., 26, and 66 based on the arrangement result.

In operation 420, the battery state estimating apparatus 120 determines state information of the batteries 1 through 96 in each of switching periods T97 through T192 based on the updated order.

The battery state estimating apparatus 120 repeats the operations described with respect to FIGS. 2 and 3 after an (N+1)-th order update period.

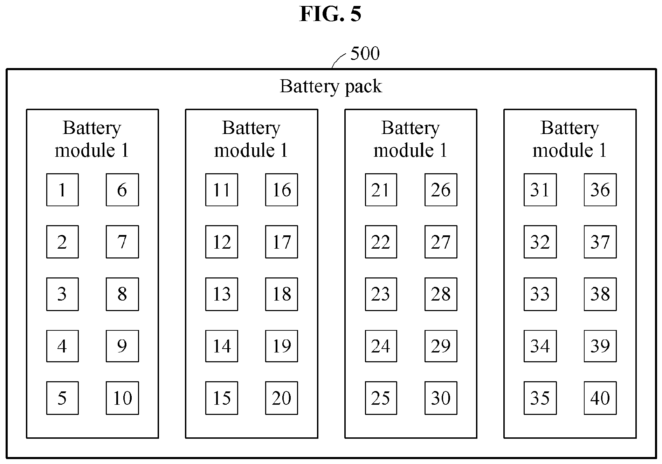

FIGS. 5 through 8 illustrate examples of a battery state estimating apparatus grouping batteries.

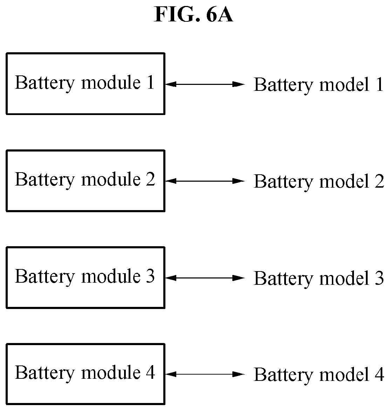

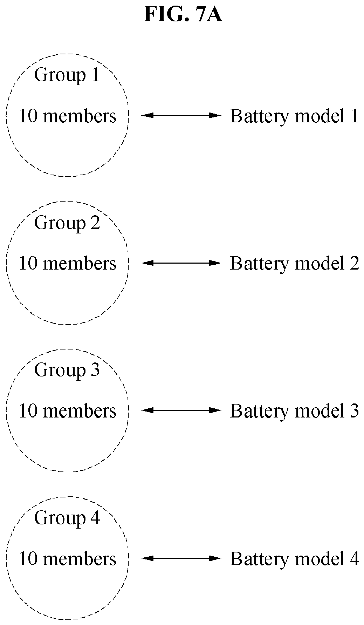

The battery state estimating apparatus 120 may include a plurality of battery models, and group the batteries 110-1 through 110-n to be assigned to a corresponding battery model. For example, in a case in which a battery pack 500 includes battery modules 1 through 4 and each of the battery modules 1 through 4 includes a plurality of battery cells, as shown in FIG. 5, the battery state estimating apparatus 120 forms groups by performing module-based grouping or cell-based grouping, and assigns the battery models to the groups. The module-based grouping will be described with reference to FIGS. 6A through 6D, and the cell-based grouping will be described with reference to FIGS. 7A through 7C.

In an example, the battery state estimating apparatus 120 may include the same number of battery models as a number of battery modules. That is, the number of battery models in the battery state estimating apparatus 120 may be equal to the number of battery modules. In this example, the battery state estimating apparatus 120 configures battery cells belonging to each battery module as a single group. In the example of FIG. 6A, the number of battery models is "4," and the number of battery modules is "4". The battery state estimating apparatus 120 sets or configures battery cells belonging to a battery module 1 or the battery module 1 as a group 1, and assigns a battery model 1 to the group 1. The battery state estimating apparatus 120 sets battery cells belonging to a battery module 2 or the battery module 2 as a group 2, and assigns a battery model 2 to the group 2. Further, the battery state estimating apparatus 120 sets battery cells belonging to a battery module 3 or the battery module 3 as a group 3, and assigns a battery model 3 to the group 3. The battery state estimating apparatus 120 sets battery cells belonging to a battery module 4 or the battery module 4 as a group 4, and assigns a battery model 4 to the group 4.

In another example, the battery state estimating apparatus 120 may include a different number of battery models from a number of battery modules. That is, the number of battery models in the battery state estimating apparatus 120 may be different from the number of battery modules.

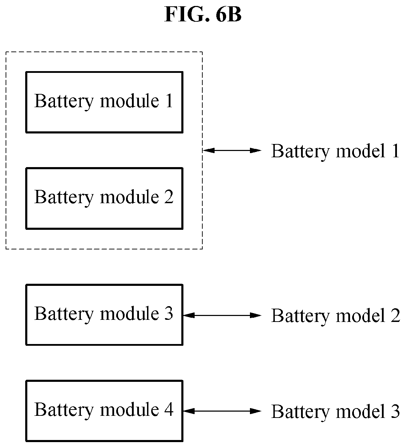

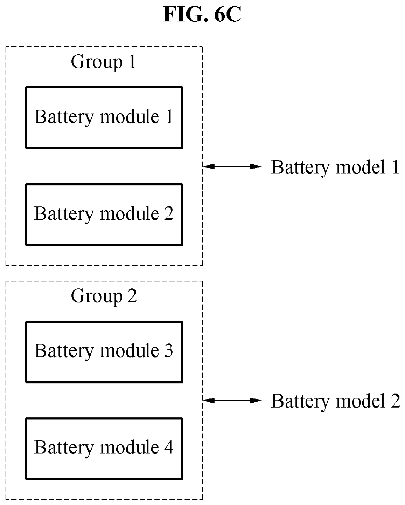

As an example, the number of battery models may be less than the number of battery modules. In this example, the battery state estimating apparatus 120 forms or interprets battery cells belonging to different battery modules as a single group. In the example of FIG. 6B, the number of battery modules is "4," and the number of battery models is "3". In this example, the battery state estimating apparatus 120 sets battery cells belonging to a battery module 1 and battery cells belonging to a battery module 2 or the battery modules 1 and 2 as a group 1, and assigns a battery model 1 to the group 1. The battery state estimating apparatus 120 sets battery cells belonging to a battery module 3 or the battery module 3 as a group 2, and assigns a battery model 2 to the group 2. The battery state estimating apparatus 120 sets battery cells belonging to a battery module 4 or the battery module 4 as a group 3, and assigns a battery model 3 to the group 3. In the example of FIG. 6C, the number of battery modules is "4," and the number of battery models is "2". In this example, the battery state estimating apparatus 120 forms battery cells belonging to battery modules 1 and 2 as a group 1, and forms battery cells belonging to battery modules 3 and 4 as a group 2. The battery state estimating apparatus 120 assigns a battery model 1 to the group 1, and assigns a battery model 2 to the group 2.

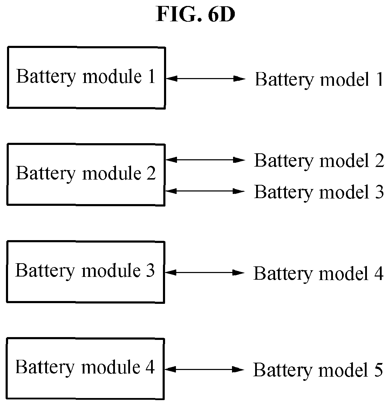

As another example, the number of battery models in the battery state estimating apparatus 120 may be greater than the number of battery modules. In this example, the battery state estimating apparatus 120 selects at least one battery module from the battery modules and assigns thereto two of more battery models. For example, the battery state estimating apparatus 120 selects the at least one battery module based on SOCs, SOHs, or abnormality states of the battery modules, or selects the at least one battery module at random. Then the battery state estimating apparatus 120 assigns at least two battery models to the selected at least one battery module. In the example of FIG. 6D, the number of battery modules is "4" and the number of battery models is "5". In this example, the battery state estimating apparatus 120 selects a battery module 2 having a highest SOC. The battery state estimating apparatus 120 assigns battery models 2 and 3 to the selected battery module 2.

In an example, the battery state estimating apparatus 120 includes N battery models, and the battery pack 500 includes M battery cells. Here, M and N are integers, and M and N are equal to or different from each other. In this example, the battery state estimating apparatus 120 divides the battery cells into N groups. Here, a number of members of each group is equal or different.

First, a case in which the number of members of each group is equal will be described. The battery state estimating apparatus 120 groups the battery cells into the N groups such that each of the N groups includes the same number of members. That is, the number of battery cells belonging to each group is equal to M/N. In an example of FIG. 7A, the number of battery models is "4," and the number of battery cells is "40". In this example, the battery state estimating apparatus 120 divides the "40" battery cells into "4" groups such that each group includes equally "10" members. The battery state estimating apparatus 120 assigns battery models 1 through 4 to the "4" groups, respectively.

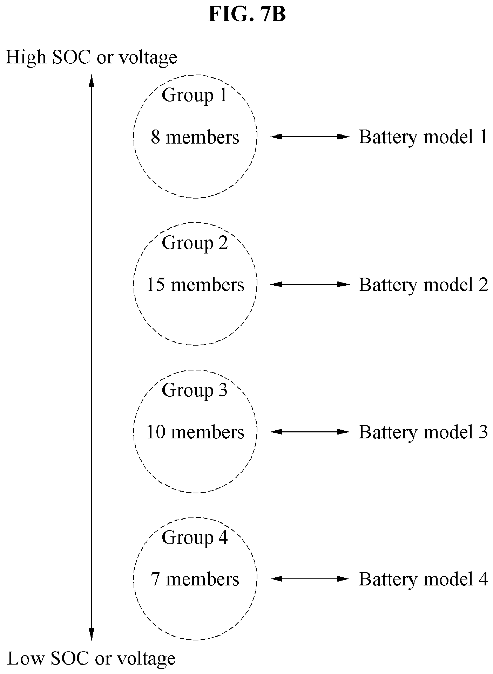

The battery state estimating apparatus 120 may group the battery cells such that each group includes a different number of members. For example, the battery state estimating apparatus 120 divides or allocates the battery cells into N groups such that same groups includes fewer number of battery cells. In an example of FIG. 7B, the battery state estimating apparatus 120 forms "8" battery cells with determined relatively high SOCs as a group 1, and forms "7" battery cells with determined relatively low SOCs as a group 4. The battery state estimating apparatus 120 forms "15" battery cells with determined relatively high SOCs, among remaining "25" battery cells, as a group 2, and forms remaining "10" battery cells as a group 3. Herein, relatively high and low determination of SOCs can be performed based on predetermined high or low thresholds. Intermediate predetermined levels may also be determined. The battery state estimating apparatus 120 assigns battery models 1 through 4 to the "4" groups, respectively. However, the number of members of each group is provided only as an example and thus is not limited to the above example. Unlike the example of FIG. 7B, the number of members of the group 1 may be equal to the number of members of the group 4, the number of members of the group 2 may be equal to the number of members of the group 3, and the number of members of each of the group 1 and the group 4 may be less than the number of members of each of the group 2 and the group 3.

The number of members of the group 1 and/or the group 4 described with reference to FIG. 7B may be "1". For example, the battery state estimating apparatus 120 may form a group 1 including only a battery cell with the highest SOC as a member, a group 4 including only a battery cell with a lowest SOC as a member, and a group 2 and a group 3 including remaining battery cells based on SOCs of the remaining battery cells.

If the number of battery models is "3" in the example of FIG. 7B, the battery state estimating apparatus 120 may form a group 1 including "10" battery cells with relatively high SOCs, a group 3 including "10" battery cells with relatively low SOCs, and a group 2 including remaining "20" battery cells.

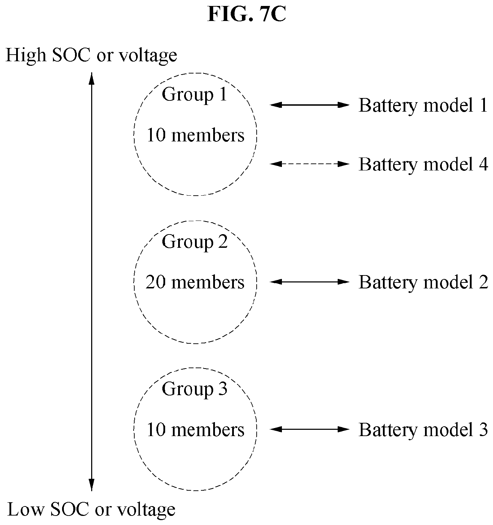

In another example, the battery state estimating apparatus 120 divides the battery cells into N or fewer groups. Unlike the description with reference to FIGS. 7A and 7B, in an example of FIG. 7C, the battery state estimating apparatus 120 including "4" battery models divides the "40" battery cells into "3" groups, rather than "4" groups. In the example of FIG. 7C, the number of members of the group 1 is "10", the number of members of the group 2 is "20", and the number of members of the group 3 is "10". However, the number of members of each group is provided only as an example and thus is not limited to the above example. In this example, the battery state estimating apparatus 120 may select a group from the groups 1 through 3 in view of any one or any combination of SOCs, SOHs, and abnormality states, and assign two or more battery models to the selected group. When the battery state estimating apparatus 120 selects the group 1 with the highest SOCs, the battery state estimating apparatus 120 may assign the battery models 1 and 4 to the group 1. The battery state estimating apparatus 120 may assign the battery model 2 to the group 2 and the battery model 3 to the group 3.

In a case of cell-based grouping, the battery cells are grouped without limiting to physical structures. That is, battery cells belonging to the same battery module belong to different groups, and battery cells belonging to different battery modules may belong to the same groups. The battery state estimating apparatus 120 sets battery cells having similar performances or characteristics as a group, without limiting to physical structures, and estimates states of the battery cells in the corresponding group. Therefore, the accuracy of estimating the states of the battery cells in the corresponding group may improve.

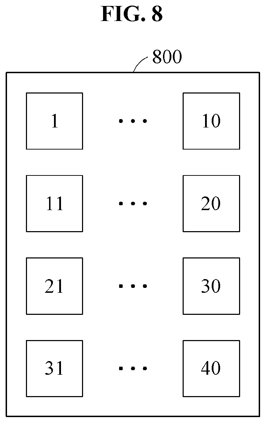

The battery pack 500 described with reference to FIG. 5 has multiple battery modules in which a plurality of battery cells are modularized. As shown in an example of FIG. 8, a plurality of battery cells are formed or allocated as a single battery pack 800. In this example, the battery state estimating apparatus 120 groups the battery cells in the battery pack 800 using the cell-based grouping described above.

FIGS. 9A through 10B illustrate examples of a battery state estimating apparatus determining state information of batteries in a group.

In examples of FIGS. 9A through 9C, battery cells 1 through 10 are formed or allocated as a group 1, and battery cells 11 through 20 are formed or allocated as a group 2. Further, battery cells 21 through 30 are formed or allocated as a group 3, and battery cells 31 through 40 are formed or allocated as a group 4. The groups 1 through 4 are formed or allocated by the battery state estimating apparatus 120 performing the module-based grouping or the cell-based grouping described above. The battery state estimating apparatus 120 assigns battery models 1 through 4 to the groups 1 through 4, respectively. The battery state estimating apparatus 120 performs the operations described with reference to FIGS. 2 through 4 with respect to the groups 1 through 4. That is, the battery state estimating apparatus 120 performs the operations described with reference to FIGS. 2 through 4 with respect to each group, thereby determining state information of battery cells belonging to each group. Results of performing the operations by the battery state estimating apparatus 120 with respect to each group are shown in FIGS. 9A through 9C.

A hatched region of FIGS. 9A through 9C indicates a battery cell of which state information is determined using a battery model. In other words, the hatched region of FIGS. 9A through 9C represents a target battery in each switching period. For example, in a switching period T5, regions corresponding to a battery 5 of a group 1, a battery 15 of a group 2, a battery 25 of a group 3, and a battery 35 of a group 4 are marked with hatches. The hatches in the switching period T5 indicates that in the switching period T5, state information of each of the battery 5, the battery 15, the battery 25, and the battery 35 are determined by a battery model assigned to each group. In other words, in the switching period T5, a target battery of the group 1 is the battery cell 5, a target battery of the group 2 is the battery cell 15, a target battery of the group 3 is the battery 25, and a target battery of the group 4 is the battery cell 35.

The following Table 5 shows an example of state information of the battery cells 1 through 40 in a last switching period T37.

[Table 5]

| Groups | Battery No. | State information |
|---|---|---|
| Group 1 | Battery 1 | $\alpha_{37}$ |
| | Battery 2 | $\alpha_{36}+\triangle_{37}$ |
| | ... | ... |
| | Battery 10 | $\alpha_{28}+\triangle_{29}+...+\triangle_{37}$ |
| Group 2 | Battery 11 | $\beta_{37}$ |
| | Battery 12 | $\beta_{36}+\triangle_{37}$ |
| | ... | ... |
| | Battery 20 | $\beta_{28}+\triangle_{29}+...+\triangle_{37}$ |
| Group 3 | Battery 21 | $\gamma_{37}$ |
| | Battery 22 | $\gamma_{36}+\triangle_{37}$ |
| | ... | ... |
| | Battery 30 | $\gamma_{28}+\triangle_{29}+...+\triangle_{37}$ |
| Group 4 | Battery 31 | $\delta_{37}$ |
| | Battery 32 | $\delta_{36}+\triangle_{37}$ |
| | ... | ... |
| | Battery 40 | $\delta_{28}+\triangle_{29}+...+\triangle_{37}$ |

In the above Table 5, $\alpha_T$ denotes state information of a target battery of a group 1 in a switching period, and is determined by a battery model 1 assigned to the group 1 in the switching period. $\beta_T$ denotes state information of a target battery of a group 2 in a switching period, and is determined by a battery model 2 assigned to the group 2 in the switching period. Further, $\gamma_T$ denotes state information of a target battery of a group 3 in a switching period, and is determined by a battery model 3 assigned to the group 3 in the switching period. $\delta_T$ denotes state information of a target battery of a group 4 in a switching period, and is determined by a battery model 4 assigned to the group 4. T in $\alpha_T$, $\beta_T$, $\gamma_T$, and $\delta_T$ denotes a switching period.

The description provided with reference to FIGS. 1 through 8 are applicable to the description provided with reference to FIGS. 9A through 9C, and thus duplicate description will be omitted herein for conciseness.

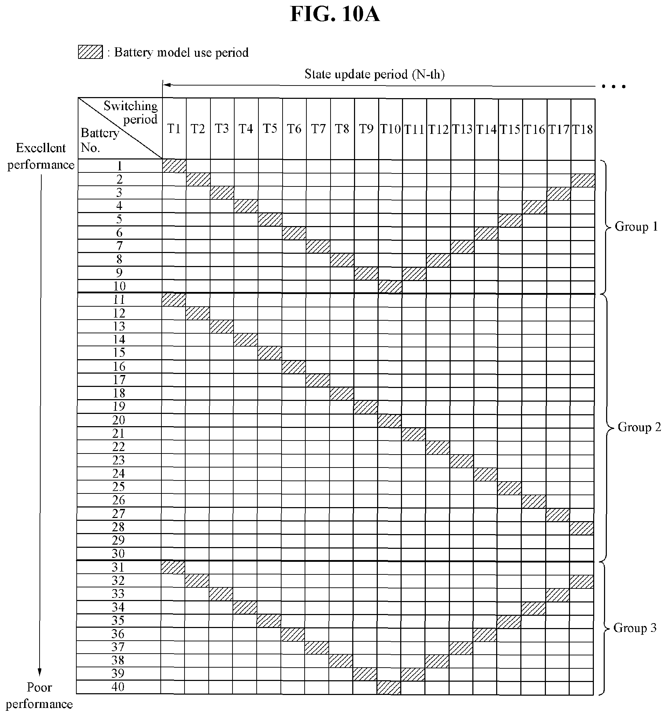

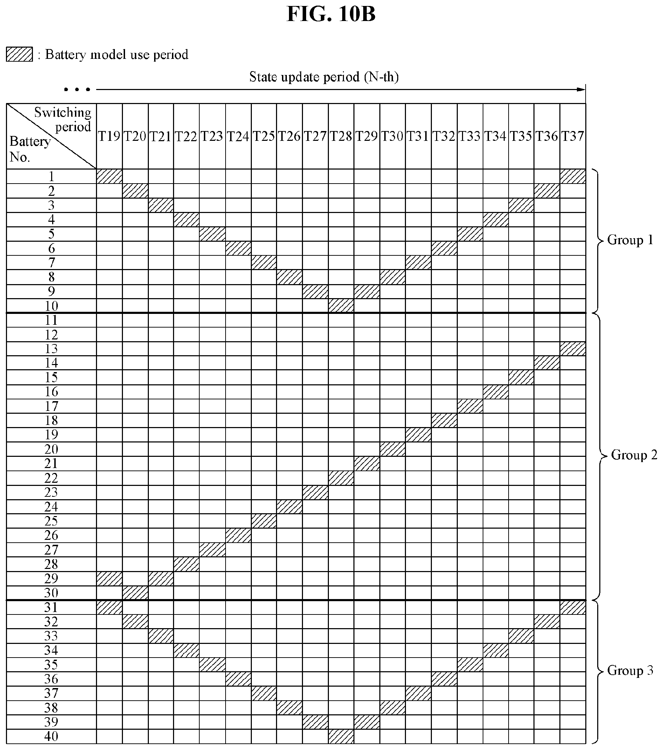

In examples of FIGS. 10A and 10B, battery cells 1 through 10 are formed or allocated as a group 1, battery cells 11 through 30 are formed or allocated as a group 2, and battery cells 31 through 40 are formed or allocated as a group 3. The groups 1 through 3 are formed or allocated by the battery state estimating apparatus 120 performing the module-based grouping or the cell-based grouping described above. The battery state estimating apparatus 120 assigns battery models 1 through 3 to the groups 1 through 3.

The number of members of each of the groups 1 and 3 are less than the number of members of the group 2. Thus, the number of times state information of the members of each of the groups 1 and 3 is determined by utilizing a battery model is greater than that for the members of the group 2. That is, a total number of times a member of each of the groups 1 and 3 becomes a target battery is greater than a total number of times a member of the group 2 becomes a target battery. For example, a number of times state information of a battery cell 12 of the group 2 is determined by utilizing the battery model 2 assigned to the group 2 is "1". However, a total number of times state information of each of a battery cell 2 of the group 1 and a battery cell 32 of the group 3 is determined by utilizing a battery model assigned to each group is "4". That is, in the examples of FIG. 10A and 10B, a total number of the hatched regions with respect to each of the battery cell 2 and the battery cell 32 is "4", which is greater than that of the battery cell 12 of the group 2. Thus, states of the battery cells 2 and 32 are estimated more accurately.

Further, if the batteries 1 through 40 are grouped such that a portion of the groups includes fewer members, the battery state estimating apparatus 120 prevents over-discharging or over-charging of batteries in the group including fewer members. For example, when the battery cells 1 through 40 are being charged, the battery state estimating apparatus 120 more accurately and frequently checks state information of the battery cells belonging to the group 1 with relatively high SOCs using the battery model 1 assigned to the group 1, thereby controlling charging to prevent over-charging of the battery cells belonging to the group 1. When the battery cells 1 through 40 are being discharged, the battery state estimating apparatus 120 more accurately and frequently checks state information of the battery cells belonging to the group 3 with relatively low SOCs using the battery model 3 assigned to the group 3, thereby controlling discharging to prevent over-discharging of the battery cells belonging to the group 3.

The description provided with reference to FIGS. 1 through 8 apply to the description provided with reference to FIGS. 10A and 10B, and thus the duplicate description will be omitted herein for conciseness.

FIGS. 11A through 11C illustrate examples of a group update of a battery state estimating apparatus.

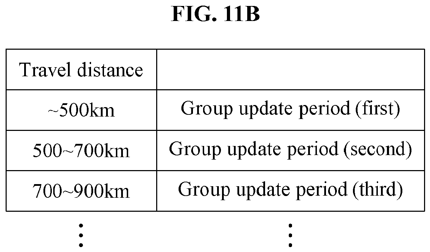

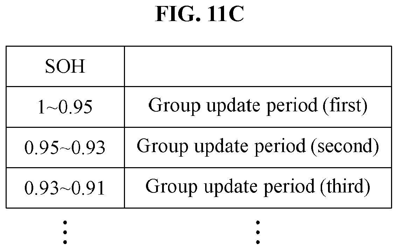

The battery state estimating apparatus 120 performs a group update in response to a group update event occurring during a current group update period. The group update occurs based on, for example, any one or any combination of a determined elapse of a predetermined time, travel distance of a vehicle, and SOH or deterioration degree. Referring to an example of FIG. 11A, a length of the group update period corresponds to a first order update period through an N-th order update period. The first through N-th order updates are performed during the first group update period. When the N-th order update period elapses, the group update event occurs. Referring to an example of FIG. 11B, the group update event occurs based on a travel distance of a vehicle on which the battery state estimating apparatus 120 is mounted. For example, when the travel distance of the vehicle is determined greater than or equal to a predetermined distance, e.g. 700 km, the group update event occurs. In this example, although a time corresponding to a length of the group update period described with reference to FIG. 11A does not elapse, the group update event may occur. Referring to an example of FIG. 11C, the group update event occurs based on a SOH or deterioration degree of the battery pack 500 or 800. For example, when a SOH of the battery pack 500 or 800 is less than 0.91, the group update event occurs. In this example, although a time corresponding to the length of the group update period described with reference to FIG. 11A does not elapse, the group update event may occur.

By the group update, any one or any combination of members belonging to each of groups, a number of members of each group, and a number of groups are changed. For example, suppose that during a first group update period, battery cells 1 through 10 belong to a group 1, battery cells 11 through 20 belong to a group 2, battery cells 21 through 30 belong to a group 3, and battery cells 31 through 40 belong to a group 4. In response to an occurrence of the group update event, the battery state estimating apparatus 120 regroups the battery cells 1 through 40 by performing the module-based grouping or the cell-based grouping described above. By the group update, members of each group and/or a number of members may be changed. For example, "9" battery cells may belong to a group 1, "11" battery cells may belong to a group 2, "13" battery cells may belong to a group 3, and "7" battery cells may belong to a group 4. Further, by the group update, a number of groups may be changed. For example, the number of groups may decrease from "4" to "3" or fewer, or increase to "5" or more. Also, although such a group update is performed, the members of each group may remain unchanged.

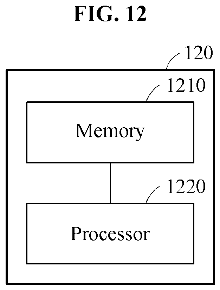

FIG. 12 illustrates an example of a battery state estimating apparatus.

Referring to FIG. 12, the battery state estimating apparatus 120 includes a memory 1210 and a processor 1220.

The memory 1210 is connected to the processor 1220, and stores instructions executable by the processor 1220. The memory 1210 includes a non-transitory computer-readable medium, for example, a high-speed random-access memory and/or a non-volatile computer-readable storage medium.

The processor 1220 executes instructions for performing the at least one operation described with reference to FIGS. 1 through 11C. For example, the processor 1220 determines state information of the batteries 110-1 through 110-n in each of switching periods. Here, the processor 1220 determines state information of a target battery in each switching period based on a battery model and sensing data of the target battery in each switching period, and determines state information of a non-target battery in each switching period based on a state variation of the non-target battery in each switching period. The processor 1220 outputs state information of the batteries 110-1 through 110-n in a last switching period of the switching periods.

The processor 1220 updates a relationship set for the batteries 110-1 through 110-n based on any one or any combination of voltage values of the batteries 110-1 through 110-n and the state information of the batteries 110-1 through 110-n in the last switching period. The relationship indicates, for example, the order or the groups described above.

The description provided with reference to FIGS. 1 through 11C are applicable to the description provided with reference to FIG. 12, and thus duplicate description will be omitted herein for conciseness.

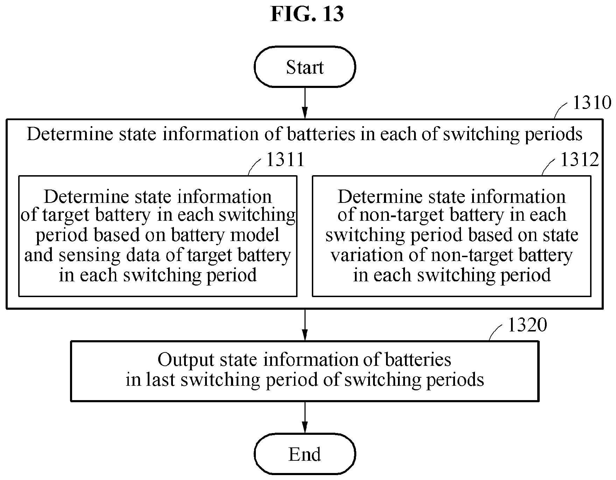

FIG. 13 illustrates an example of a battery state estimating method.

The battery state estimating method is performed by the battery state estimating apparatus 120.

Referring to FIG. 13, in operation 1310, the battery state estimating apparatus 120 determines state information of the batteries 110-1 through 110-n in each of switching periods. In detail, the battery state estimating apparatus 120 determines state information of a target battery in each switching period based on a battery model and sensing data of the target battery in each switching period in operation 1311, and determines state information of a non-target battery in each switching period based on a state variation of the non-target battery in each switching period in operation 1312.

In operation 1320, the battery state estimating apparatus 120 outputs state information of the batteries 110-1 through 110-n in a last switching period of the switching periods.

The description provided with reference to FIGS. 1 through 11C are applicable to the description provided with reference to FIG. 13, and thus duplicate description will be omitted herein for conciseness.

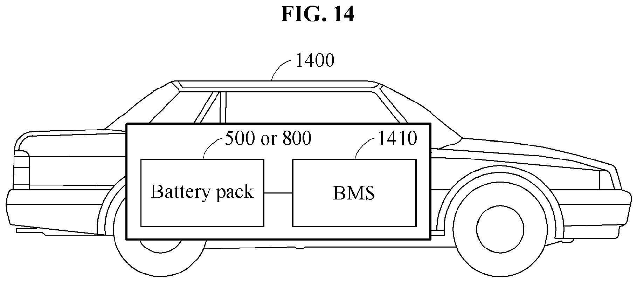

The battery state estimating apparatus 120 may be mounted on various electronic devices using batteries as a power source, for example, a vehicle, a walking assistance device, a drone, and a mobile terminal, and performs the operations described with reference to FIGS. 1 through 13. Hereinafter, a case in which the battery state estimating apparatus 120 is mounted on a vehicle will be described with reference to FIG. 14. The description of FIG. 14 is also applicable to other electronic devices.

FIG. 14 illustrates an example of a vehicle.

Referring to FIG. 14, a vehicle 1400 includes the battery pack 500 or 800, and a battery management system (BMS) 1410. The vehicle 1400 is, for example, an electric vehicle or a hybrid vehicle.

The BMS 1410 monitors whether an abnormality occurs in the battery pack 500 or 800, and prevents over-charging or over-discharging of the battery pack 500 or 800. Further, the BMS 1410 performs thermal control with respect to the battery pack 500 or 800 in response to a measured temperature of the battery pack 500 or 800 exceeding a first temperature, for example, 40°C, or being less than a second temperature, for example, -10°C. In addition, the BMS 1410 performs cell balancing such that charge states of battery cells included in the battery pack 500 or 800 are equalized.

In an example, the BMS 1410 includes the battery state estimating apparatus 120, and determines state information of the battery cells in the battery pack 500 or 800 through the battery state estimating apparatus 120. The BMS 1410 may determine a maximum value, a minimum value, or an average value of the state information of the battery cells to be state information of the battery pack 500 or 800.

The BMS 1410 transmits the state information of the battery pack 500 or 800 to an electronic control unit (ECU) or a vehicle control unit (VCU) of the vehicle 1400. The ECU or the VCU of the vehicle 1400 outputs the state information of the battery pack 500 or 800 on a display of the vehicle 1400.

The battery state estimating apparatus 120, the BMS 1410 and other apparatuses, units, modules, devices, and other components described herein with respect to FIGS. 1, 12 and 14 are implemented by hardware components configured to perform the operations described in this application that are performed by the hardware components. Examples of hardware components that may be used to perform the operations described in this application where appropriate include controllers, sensors, generators, drivers, memories, comparators, arithmetic logic units, adders, subtractors, multipliers, dividers, integrators, and any other electronic components configured to perform the operations described in this application. In other examples, one or more of the hardware components that perform the operations described in this application are implemented by computing hardware, for example, by one or more processors or computers. A processor or computer may be implemented by one or more processing elements, such as an array of logic gates, a controller and an arithmetic logic unit, a digital signal processor, a microcomputer, a programmable logic controller, a field-programmable gate array, a programmable logic array, a microprocessor, or any other device or combination of devices that is configured to respond to and execute instructions in a defined manner to achieve a desired result. In one example, a processor or computer includes, or is connected to, one or more memories storing instructions or software that are executed by the processor or computer. Hardware components implemented by a processor or computer may execute instructions or software, such as an operating system (OS) and one or more software applications that run on the OS, to perform the operations described in this application. The hardware components may also access, manipulate, process, create, and store data in response to execution of the instructions or software. For simplicity, the singular term "processor" or "computer" may be used in the description of the examples described in this application, but in other examples multiple processors or computers may be used, or a processor or computer may include multiple processing elements, or multiple types of processing elements, or both. For example, a single hardware component or two or more hardware components may be implemented by a single processor, or two or more processors, or a processor and a controller. One or more hardware components may be implemented by one or more processors, or a processor and a controller, and one or more other hardware components may be implemented by one or more other processors, or another processor and another controller. One or more processors, or a processor and a controller, may implement a single hardware component, or two or more hardware components. A hardware component may have any one or more of different processing configurations, examples of which include a single processor, independent processors, parallel processors, single-instruction single-data (SISD) multiprocessing, single-instruction multiple-data (SIMD) multiprocessing, multiple-instruction single-data (MISD) multiprocessing, and multiple-instruction multiple-data (MIMD) multiprocessing.

The method illustrated in FIG. 13 that perform the operations described in this application are performed by computing hardware, for example, by one or more processors or computers, implemented as described above executing instructions or software to perform the operations described in this application that are performed by the method. For example, a single operation or two or more operations may be performed by a single processor, or two or more processors, or a processor and a controller. One or more operations may be performed by one or more processors, or a processor and a controller, and one or more other operations may be performed by one or more other processors, or another processor and another controller. One or more processors, or a processor and a controller, may perform a single operation, or two or more operations.

Instructions or software to control computing hardware, for example, one or more processors or computers, to implement the hardware components and perform the methods as described above may be written as computer programs, code segments, instructions or any combination thereof, for individually or collectively instructing or configuring the one or more processors or computers to operate as a machine or special-purpose computer to perform the operations that are performed by the hardware components and the methods as described above. In one example, the instructions or software include machine code that is directly executed by the one or more processors or computers, such as machine code produced by a compiler. In another example, the instructions or software includes higher-level code that is executed by the one or more processors or computer using an interpreter. The instructions or software may be written using any programming language based on the block diagrams and the flow charts illustrated in the drawings and the corresponding descriptions in the specification, which disclose algorithms for performing the operations that are performed by the hardware components and the methods as described above.

The instructions or software to control computing hardware, for example, one or more processors or computers, to implement the hardware components and perform the methods as described above, and any associated data, data files, and data structures, may be recorded, stored, or fixed in or on one or more non-transitory computer-readable storage media. Examples of a non-transitory computer-readable storage medium include read-only memory (ROM), random-access memory (RAM), flash memory, CD-ROMs, CD-Rs, CD+Rs, CD-RWs, CD+RWs, DVD-ROMs, DVD-Rs, DVD+Rs, DVD-RWs, DVD+RWs, DVD-RAMs, BD-ROMs, BD-Rs, BD-R LTHs, BD-REs, magnetic tapes, floppy disks, magneto-optical data storage devices, optical data storage devices, hard disks, solid-state disks, and any other device that is configured to store the instructions or software and any associated data, data files, and data structures in a non-transitory manner and provide the instructions or software and any associated data, data files, and data structures to one or more processors or computers so that the one or more processors or computers can execute the instructions. In one example, the instructions or software and any associated data, data files, and data structures are distributed over network-coupled computer systems so that the instructions and software and any associated data, data files, and data structures are stored, accessed, and executed in a distributed fashion by the one or more processors or computers.

While this disclosure includes specific examples, it will be apparent after an understanding of the disclosure of this application that various changes in form and details may be made in these examples without departing from the scope of the claims. The examples described herein are to be considered in a descriptive sense only, and not for purposes of limitation. Descriptions of features or aspects in each example are to be considered as being applicable to similar features or aspects in other examples. Suitable results may be achieved if the described techniques are performed in a different order, and/or if components in a described system, architecture, device, or circuit are combined in a different manner, and/or replaced or supplemented by other components or their equivalents. Therefore, the scope of the disclosure is defined not by the detailed description, but by the claims.

**Claims**

1. A processor-implemented battery state estimation method, the method comprising:

   determining state information of plural batteries in each of plural switching periods, the determining comprising determining, for each switching period, state information of a target battery based on a battery model and sensing data of the target battery, and state information of a non-target battery based on a state variation of the non-target battery, wherein the target battery is changed in each switching period, the state information includes charge state information, and the state variation is determined based on a reference capacity and an amount of current flowing in the plural batteries; and

outputting the state information of the batteries in a last switching period of the switching periods,

wherein a target battery set in a first switching period of the plural switching periods is set to be a non-target battery in a second switching period of the plural switching periods, and a non-target battery in the first switching period is set to be a target battery in the second switching period of the plural switching periods.

2. The battery state estimation method of claim 1, further comprising:

updating a relationship set for the batteries based on any one or any combination of voltage values of the plural batteries and the state information of the plural batteries in the last switching period, or

further comprising:

grouping subsets of the plural batteries into groups and assigning respective battery models to the groups.

3. The battery state estimation method of claim 2, wherein the set relationship indicates an order indicating which of the plural batteries is the target battery in each of the plural switching periods, or which groups are formed by grouping the plural batteries.

4. The battery state estimation method of claim 2, wherein the determining of the state information of the target battery comprises determining state information of a corresponding target battery in each of the groups in each of the plural switching periods based on the respective battery model assigned to each group and sensing data of the corresponding target battery in each group.

5. The battery state estimation method of claim 2, wherein a respective total number of members of each of the groups is equal or different, and a respective total number of the groups is less than or equal to a total number of the batteries, or

further comprising regrouping the subsets of batteries in response to a group update event occurring as the state information of the batteries in the last switching period is determined, wherein the group update event occurs based on any one or any combination of any two or more of a preset interval, a travel distance of a vehicle using the plural batteries as a power source, and the determined state information, or

wherein the grouping and assigning comprises grouping the subsets of the batteries based on any one or any combination of previous state information and voltage values of the batteries.

6. The battery state estimation method of claim 5, wherein the previous state information further comprises health state information and/or abnormality state information of the batteries determined before a first switching period of the switching periods.

7. The battery state estimation method of one of claims 1 to 6, wherein the determining of the state information of the non-target batteries comprise determining the state information of the non-target batteries in respective switching periods by adding the respective state variations to previous state information of the respective non-target batteries in the respective switching periods, or

wherein the determining of the state information of the target battery includes determining state information of a different target battery in respective multiple different switching periods of the plural switching periods, the different target battery being a respective non-target battery in other respective switching periods of the plural switching periods

8. The battery state estimation method of one of claims 1 to 7, wherein the plural batteries are respective battery cells, battery modules, or battery packs, or wherein the battery model is an electrochemical model.

9. An apparatus with battery state estimation, the apparatus comprising:

a processor, to determine state information of plural batteries in each of plural switching periods, configured to:

determine, for each switching period, state information of a target battery based on a battery model and sensing data of the target battery, and state information of a non-target battery based on a state variation of the non-target battery wherein the target battery is changed in each switching period, the state information includes charge state information, and the state variation is determined based on a reference capacity and an amount of current flowing in the plural batteries , and

output the state information of the batteries in a last switching period of the switching periods,

wherein a target battery set in a first switching period of the plural switching periods is set to be a non-target battery in a second switching period of the plural switching periods, and a non-target battery in the first switching period is set to be a target battery in the second switching period of the plural switching periods.

10. The apparatus of claim 9, wherein the processor is further configured to update a relationship set for the batteries based on any one or any combination of voltage values of the batteries and the state information of the batteries in the last switching period, or wherein the processor is further configured to group subsets of the plural batteries into groups and assign battery models to the respective groups.

11. The apparatus of claim 10, wherein the relationship set indicates an order indicating which of the plural batteries is the target battery in each of the plural switching periods, or which groups are formed by grouping the plural batteries.

12. The apparatus of claim 10, wherein the processor is further configured to determine state information of a corresponding target battery in each of the groups in the each of the plural switching periods based on the respective battery model assigned to each group and sensing data of the corresponding target battery in each group.

13. The apparatus of claim 10, wherein a respective total number of members of each of the groups is equal or different, and a respective total number of the groups is less than or equal to a total number of the batteries, or

wherein the processor is further configured to regroup the subsets of the batteries in response to a group update event occurring as the state information of the batteries in the last switching period is determined, wherein the group update event occurs based on any one or any combination of any two or more of a preset interval, a travel distance of a vehicle using the plural batteries as a power source, and the determined state information, or wherein the processor is further configured to group the subsets of the batteries based on any one or any combination of previous state information and voltage values of the batteries.

14. The apparatus of claim 13, wherein the previous state information further comprises health state information and/or abnormality state information of the batteries determined before a first switching period of the switching periods, or wherein the processor is further configured to determine the state information of the non-target batteries in the respective switching periods by adding the respective state variations to previous state information of the respective non-target batteries in the respective switching periods.

15. The apparatus of one of claims 9 to 14, wherein the battery model is an electrochemical model.

**Patentansprüche**

1. Prozessor-implementiertes Verfahren für Schätzung eines Batteriezustandes, wobei das Verfahren umfasst:

Bestimmen von Zustandsinformationen mehrerer Batterien in jeder von mehreren Schaltperioden, wobei das Bestimmen für jede Schaltperiode Bestimmen von Zustandsinformationen einer zu bestimmenden Batterie auf Basis eines Batteriemodells und von Messdaten der zu bestimmenden Batterie sowie von Zustandsinformationen einer nicht zu bestimmenden Batterie auf Basis einer Zustandsänderung der nicht zu bestimmenden Batterie umfasst, die zu bestimmende Batterie in jeder Schaltperiode geändert wird, die Zustands-informationen Lade-Zustandsinformationen einschließen und die Zustandsänderung auf Basis einer Bezugs-Kapazität sowie einer Menge in den mehreren Batterien fließenden Stroms bestimmt wird; sowie Ausgeben der Zustandsinformationen der Batterien in einer letzten Schaltperiode der Schaltperioden, wobei eine zu bestimmende Batterie, die in einer ersten Schaltperiode der mehreren Schaltperioden festgelegt wird, so festgelegt wird, dass sie in einer zweiten Schaltperiode der mehreren Schaltperioden eine nicht zu bestimmende Batterie ist, und eine in der ersten Schaltperiode nicht zu bestimmende Batterie so festgelegt wird, dass sie in der zweiten Schaltperiode der mehreren Schaltperioden eine zu bestimmende Batterie ist.

2. Verfahren für Schätzung eines Batteriezustandes nach Anspruch 1, das des Weiteren umfasst:

Aktualisieren einer Beziehung, die für die Batterien auf Basis von Spannungswerten der mehreren Batterien und/oder den Zustandsinformationen der mehreren Batterien in der letzten Schaltperiode oder einer beliebigen Kombination davon festgelegt wird, oder

das des Weiteren umfasst:
Einteilen von Untermengen der mehreren Batterien in Gruppen und Zuordnen jeweiliger Batteriemodelle zu den Gruppen.

3. Verfahren für Schätzung eines Batteriezustandes nach Anspruch 2, wobei die festgelegte Beziehung eine Reihenfolge angibt, die angibt, welche der mehreren Batterien in jeder der mehreren Schaltperioden die zu bestimmende Batterie ist oder welche Gruppen durch Einteilen der mehreren Batterien gebildet werden.

4. Verfahren für Schätzung eines Batteriezustandes nach Anspruch 2, wobei das Bestimmen der Zustandsinformationen der zu bestimmenden Batterie Bestimmen von Zustandsinformationen einer entsprechenden zu bestimmenden Batterie in jeder der Gruppen in jeder der mehreren Schaltperioden auf Basis des jeweiligen, jeder Gruppe zugeordneten Batteriemodells und von Messdaten der entsprechenden zu bestimmenden Batterie in jeder Gruppe umfasst.

5. Verfahren für Schätzung eines Batteriezustandes nach Anspruch 2, wobei eine jeweilige Gesamtzahl von Mitgliedern jeder der Gruppen gleich oder unterschiedlich ist und eine jeweilige Gesamtzahl der Gruppen kleiner ist als oder genauso groß wie eine Gesamtzahl der Batterien, oder

es des Weiteren neues Einteilen der Untermengen von Batterien in Reaktion auf ein Gruppen-Aktualisierungsereignis umfasst, das stattfindet, wenn die Zustandsinformationen der Batterien in der letzten Schaltperiode bestimmt werden, wobei das Gruppen-Aktualisierungsereignis auf Basis eines voreingestellten Intervalls, einer Fahrstrecke eines Fahrzeugs, das die mehreren Batterien als eine Energiequelle nutzt, und/oder einer beliebigen Kombination von beliebigen zwei oder mehr dieser Größen sowie der bestimmten Zustandsinformationen stattfindet, oder
das Einteilen und Zuordnen Einteilen der Untermengen der Batterien auf Basis vorangegangener Zustandsinformationen und/oder von Spannungswerten der Batterien oder einer beliebigen Kombination davon umfasst.

6. Verfahren für Schätzung eines Batteriezustandes nach Anspruch 5, wobei die vorangegangenen Zustandsinformationen des Weiteren Informationen über den Gesundheitszustand und/oder Informationen über einen Störungszustand der Batterien umfassen, die vor einer ersten Schaltperiode der Schaltperioden bestimmt wurden.

7. Verfahren für Schätzung eines Batteriezustandes nach einem der Ansprüche 1 bis 6, wobei das Bestimmen der Zustandsinformationen der nicht zu bestimmenden Batterien Bestimmen der Zustandsinformationen der nicht zu bestimmenden Batterien in jeweiligen Schaltperioden durch Hinzufügen der jeweiligen Zustandsänderungen zu vorangegangenen Zustandsinformationen der jeweiligen nicht zu bestimmenden Batterien in den jeweiligen Schaltperioden umfasst, oder
das Bestimmen der Zustandsinformationen der zu bestimmenden Batterie Bestimmen von Zustandsinformationen einer anderen zu bestimmenden Batterie in jeweiligen mehreren verschiedenen Schaltperioden der mehreren Schaltperioden einschließt, wobei die andere zu bestimmende Batterie eine jeweilige nicht zu bestimmende Batterie in anderen jeweiligen Schaltperioden der mehreren Schaltperioden ist.

8. Verfahren für Schätzung eines Batteriezustandes nach einem der Ansprüche 1 bis 7, wobei die mehreren Batterien jeweilige Batteriezellen, Batteriemodule oder Batteriepacks sind, oder
das Batteriemodell ein elektrochemisches Modell ist.

9. Vorrichtung mit Schätzung eines Batteriezustandes, wobei die Vorrichtung umfasst:

einen Prozessor zum Bestimmen von Zustandsinformationen mehrerer Batterien in jeder von mehreren Schaltperioden, der konfiguriert ist zum:

Bestimmen für jede Schaltperiode von Zustandsinformationen einer zu bestimmenden Batterie auf Basis eines Batteriemodells und von Messdaten der zu bestimmenden Batterie sowie von Zustandsinformationen einer nicht zu bestimmenden Batterie auf Basis einer Zustandsänderung der nicht zu bestimmenden Batterie, wobei die zu bestimmende Batterie in jeder Schaltperiode geändert wird, die Zustandsinformationen Lade-Zustandsinformationen einschließen und die Zustandsänderung auf Basis einer Bezugs-Kapazität sowie einer Menge in den mehreren Batterien fließenden Stroms bestimmt wird; und
Ausgeben der Zustandsinformationen der Batterien in einer letzten Schaltperiode der Schaltperioden,

wobei eine zu bestimmende Batterie, die in einer ersten Schaltperiode der mehreren Schaltperioden festgelegt wird, so festgelegt wird, dass sie in einer zweiten Schaltperiode der mehreren Schaltperioden eine nicht zu bestimmende Batterie ist, und eine in der ersten Schaltperiode nicht zu bestimmende Batterie so festgelegt wird, dass sie in der zweiten Schaltperiode der mehreren Schaltperioden eine zu bestimmende Batterie ist.

10. Vorrichtung nach Anspruch 9, wobei der Prozessor des Weiteren konfiguriert ist zum Aktualisieren einer Beziehung, die für die Batterien auf Basis von Spannungswerten der Batterien und/oder den Zustandsinformationen der mehreren Batterien in der letzten Schaltperiode oder einer beliebigen Kombination davon festgelegt wird, oder
der Prozessor des Weiteren konfiguriert ist zum Einteilen von Untermengen der mehreren Batterien in Gruppen und Zuordnen von Batteriemodellen zu den jeweiligen Gruppen.

11. Vorrichtung nach Anspruch 10, wobei die festgelegte Beziehung eine Reihenfolge angibt, die angibt, welche der mehreren Batterien in jeder der mehreren Schaltperioden die zu bestimmende Batterie ist oder welche Gruppen durch Einteilen der mehreren Batterien gebildet werden.

12. Vorrichtung nach Anspruch 10, wobei der Prozessor des Weiteren konfiguriert ist zum Bestimmen von Zustandsinformationen einer entsprechenden zu bestimmenden Batterie in jeder der Gruppen in jeder der mehreren Schaltperioden auf Basis des jeweiligen, jeder Gruppe zugeordneten Batteriemodells und von Messdaten der entsprechenden zu bestimmenden Batterie in jeder Gruppe.

13. Vorrichtung nach Anspruch 10, wobei eine jeweilige Gesamtzahl von Mitgliedern jeder der Gruppen gleich oder unterschiedlich ist und eine jeweilige Gesamtzahl der Gruppen kleiner ist als oder genauso groß wie eine Gesamtzahl der Batterien, oder

der Prozessor des Weiteren konfiguriert ist zum neuen Einteilen der Untermengen der Batterien in Reaktion auf ein Gruppen-Aktualisierungsereignis, das stattfindet, wenn die Zustandsinformationen der Batterien in der letzten Schaltperiode bestimmt werden, wobei das Gruppen-Aktualisierungsereignis auf Basis eines voreingestellten Intervalls, einer Fahrstrecke eines Fahrzeugs, das die mehreren Batterien als eine Energiequelle nutzt, und/oder einer beliebigen Kombination von beliebigen zwei oder mehr dieser Größen sowie der bestimmten Zustandsinformationen stattfindet, oder
der Prozessor des Weiteren konfiguriert ist zum Einteilen der Untermengen der Batterien auf Basis vorangegangener Zustandsinformationen und/oder von Spannungswerten der Batterien oder einer beliebigen Kombination davon.

14. Vorrichtung nach Anspruch 13, wobei die vorangegangenen Zustandsinformationen des Weiteren Informationen über den Gesundheitszustand und/oder Informationen über einen Störungszustand der Batterien umfassen, die vor einer ersten Schaltperiode der Schaltperioden ermittelt wurden, oder
der Prozessor des Weiteren konfiguriert ist zum Bestimmen der Zustandsinformationen der nicht zu bestimmenden Batterien in den jeweiligen Schaltperioden durch Hinzufügen der jeweiligen Zustandsänderungen zu vorangegangenen Zustandsinformationen der jeweiligen nicht zu bestimmenden Batterien in den jeweiligen Schaltperioden.

15. Vorrichtung nach einem der Ansprüche 9 bis 14, wobei das Batteriemodell ein elektrochemisches Modell ist.

**Revendications**

1. Procédé d'estimation d'état de batterie mis en œuvre par microprocesseur, le procédé comprenant :

détermination d'informations d'état de plusieurs batteries dans chacune de plusieurs périodes de commutation, la détermination comprenant une détermination, pour chaque période de commutation, d'informations d'état d'une batterie cible selon un modèle de batterie et des données de détection de la batterie cible, et des informations d'état d'une batterie non cible selon une variation d'état de la batterie non cible, dans lequel la batterie cible est changée dans chaque période de commutation, les informations d'état incluent des informations d'état de charge, et la variation d'état est déterminée selon une capacité de référence et une quantité de courant circulant dans les plusieurs batteries ; et
génération des informations d'état des batteries dans une dernière période de commutation des périodes de commutation,
dans lequel un ensemble de batteries cible dans une première période de commutation des plusieurs périodes de commutation est défini pour être une batterie non cible dans une deuxième période de commutation des plusieurs périodes de commutation, et une batterie non cible dans la première période de commutation est définie pour être une batterie cible dans la deuxième période de commutation des plusieurs périodes de commutation.

2. Le procédé d'estimation d'état de batterie de la revendication 1, comprenant en outre :

actualisation d'une relation définie pour les batteries selon une quelconque ou une combinaison quelconque de valeurs de tension des plusieurs batteries et des informations d'état des plusieurs batteries dans la dernière période de commutation, ou

comprenant en outre :

regroupement de sous-ensembles des plusieurs batteries en groupes et affectation de modèles de batterie respectifs aux groupes.

3. Le procédé d'estimation d'état de batterie de la revendication 2, dans lequel la relation définie indique un ordre indiquant laquelle des plusieurs batteries est la batterie cible dans chacune des plusieurs périodes de commutation, ou quels groupes sont constitués en regroupant les plusieurs batteries.

4. Le procédé d'estimation d'état de batterie de la revendication 2, dans lequel la détermination des informations d'état de la batterie cible comprend une détermination d'informations d'état d'une batterie cible correspondante dans chacun des groupes dans chacune des plusieurs périodes de commutation selon le modèle de batterie respectif affecté à chaque groupe et des données de détection de la batterie cible correspondante dans chaque groupe.

5. Le procédé d'estimation d'état de batterie de la revendication 2, dans lequel un nombre total respectif de membres de chacun des groupes est égal ou différent, et un nombre total respectif des groupes est inférieur ou égal à un nombre total des batteries, ou

comprenant en outre un regroupement des sous-ensembles de batteries en réponse à un événement d'actualisation de groupe intervenant lorsque les informations d'état des batteries dans la dernière période de commutation sont déterminées, dans lequel l'événement d'actualisation de groupe intervient selon un quelconque ou une combinaison quelconque de deux ou plus quelconques d'un intervalle prédéfini, d'une distance de déplacement d'un véhicule utilisant les plusieurs batteries en tant que source d'énergie, et des informations d'état déterminées, ou

dans lequel le regroupement et l'affectation comprennent un regroupement des sous-ensembles des batteries selon une quelconque ou une combinaison quelconque des informations d'état précédentes et des valeurs de tension des batteries.

6. Le procédé d'estimation d'état de batterie de la revendication 5, dans lequel les informations d'état précédentes comprennent en outre des informations d'état de santé et/ou des informations d'état d'anomalie des batteries déterminées avant une première période de commutation des périodes de commutation.

7. Le procédé d'estimation d'état de batterie de l'une des revendications 1 à 6, dans lequel la détermination des informations d'état des batteries non cible comprend une détermination des informations d'état des batteries non cible dans des périodes de commutation respectives en ajoutant les variations d'état respectives à des informations d'état précédentes des batteries non cible respectives dans les périodes de commutation respectives, ou

dans lequel la détermination des informations d'état de la batterie cible inclut une détermination d'informations d'état d'une batterie cible différente dans plusieurs périodes de commutation différentes respectives des plusieurs périodes de commutation, la batterie cible différente étant une batterie non cible respective dans d'autres périodes de commutation respectives des plusieurs périodes de commutation.

8. Le procédé d'estimation d'état de batterie de l'une des revendications 1 à 7, dans lequel les plusieurs batteries sont des cellules de batterie, modules de batteries ou blocs de batteries respectifs, ou

dans lequel le modèle de batterie est un modèle électrochimique.

9. Appareil avec estimation d'état de batterie, l'appareil comprenant :

un processeur, pour déterminer des informations d'état de plusieurs batteries dans chacune de plusieurs périodes de commutation, configuré pour :

déterminer, pour chaque période de commutation, des informations d'état d'une batterie cible selon un modèle de batterie et des données de détection de la batterie cible, et des informations d'état d'une batterie non cible selon une variation d'état de la batterie non cible, dans lequel la batterie cible est changée dans chaque période de commutation, les informations d'état incluent des informations d'état de charge, et la variation d'état est déterminée selon une capacité de référence et une quantité de courant circulant dans les plusieurs batteries, et

générer les informations d'état des batteries dans une dernière période de commutation des périodes de commutation,

dans lequel un ensemble de batteries cible dans une première période de commutation des plusieurs périodes de commutation est défini pour être une batterie non cible dans une deuxième période de commutation des plusieurs périodes de commutation, et une batterie non cible dans la première période de commutation est définie pour être une batterie cible dans la deuxième période de commutation des plusieurs périodes de commutation.

10. L'appareil de la revendication 9, dans lequel le processeur est configuré en outre pour actualiser une relation définie pour les batteries selon une quelconque ou une combinaison quelconque de valeurs de tension des batteries et des informations d'état des batteries dans la dernière période de commutation, ou

dans lequel le processeur est configuré en outre pour regrouper des sous-ensembles des plusieurs batteries en groupes et affecter des modèles de batterie aux groupes respectifs.

11. L'appareil de la revendication 10, dans lequel la relation définie indique un ordre indiquant laquelle des plusieurs batteries est la batterie cible dans chacune des plusieurs périodes de commutation, ou quels groupes sont constitués en regroupant les plusieurs batteries.

12. L'appareil de la revendication 10, dans lequel le processeur est configuré en outre pour déterminer des informations d'état d'une batterie cible correspondante dans chacun des groupes dans la chacune des plusieurs périodes de commutation selon le modèle de batterie respectif affecté à chaque groupe et des données de détection de la batterie cible correspondante dans chaque groupe.

13. L'appareil de la revendication 10, dans lequel un nombre total respectif de membres de chacun des groupes est égal ou différent, et un nombre total respectif des groupes est inférieur ou égal à un nombre total des batteries, ou

dans lequel le processeur est configuré en outre pour regrouper les sous-ensembles de batteries en réponse à un événement d'actualisation de groupe intervenant lorsque les informations d'état des batteries dans la dernière période de commutation sont déterminées, dans lequel l'événement d'actualisation de groupe intervient selon un quelconque ou une combinaison quelconque de deux ou plus quelconques d'un intervalle prédéfini, d'une distance de déplacement d'un véhicule utilisant les plusieurs batteries en tant que source d'énergie, et des informations d'état déterminées, ou

dans lequel le processeur est configuré en outre pour regrouper les sous-ensembles des batteries selon une quelconque ou une combinaison quelconque des informations d'état précédentes et des valeurs de tension des batteries.

14. L'appareil de la revendication 13, dans lequel les informations d'état précédentes comprennent en outre des informations d'état de santé et/ou des informations d'état d'anomalie des batteries déterminées avant une première période de commutation des périodes de commutation, ou

dans lequel le processeur est configuré en outre pour déterminer les informations d'état des batteries non cible dans les périodes de commutation respectives en ajoutant les variations d'état respectives à des informations d'état précédentes des batteries non cible respectives dans les périodes de commutation respectives.

15. L'appareil de l'une des revendications 9 à 14, dans lequel le modèle de batterie est un modèle électrochimique.

**FIG. 1**

<u>100</u>

# FIG. 2

Order update period (N-th)

/ 210

| Determine state information of batteries |
|---|

| Switching period / Battery No. | T1 | T2 | T3 | T4 | $\cdots$ | T95 | T96 | |
|---|---|---|---|---|---|---|---|---|
| 01 | $\alpha_1$ | $\triangle_2$ | $\triangle_3$ | $\triangle_4$ | | $\triangle_{95}$ | $\triangle_{96}$ | → $SOC_N$ #1 |
| 02 | $\triangle_1$ | $\alpha_2$ | $\triangle_3$ | $\triangle_4$ | | $\triangle_{95}$ | $\triangle_{96}$ | → $SOC_N$ #2 |
| 03 | $\triangle_1$ | $\triangle_2$ | $\alpha_3$ | $\triangle_4$ | $\cdots$ | $\triangle_{95}$ | $\triangle_{96}$ | → $SOC_N$ #3 |
| 04 | $\triangle_1$ | $\triangle_2$ | $\triangle_3$ | $\alpha_4$ | | $\triangle_{95}$ | $\triangle_{96}$ | → $SOC_N$ #4 |
| $\vdots$ | $\vdots$ | | $\vdots$ | | $\ddots$ | $\vdots$ | | $\vdots$ |
| 95 | $\triangle_1$ | $\triangle_2$ | $\triangle_3$ | $\triangle_4$ | | $\alpha_{95}$ | $\triangle_{96}$ | → $SOC_N$ #95 |
| 96 | $\triangle_1$ | $\triangle_2$ | $\triangle_3$ | $\triangle_4$ | $\cdots$ | $\triangle_{95}$ | $\alpha_{96}$ | → $SOC_N$ #96 |

**FIG. 3**

# FIG. 4

Order update period ((N+1)-th)

410 → Update → 420 → Determine state information of batteries

| Battery No. \ Switching period | T97 | T98 | T99 | T100 | $\cdots$ | T191 | T192 | |
|---|---|---|---|---|---|---|---|---|
| SOC$_N$ #1 → 41 | $\alpha_{97}$ | $\triangle_{98}$ | $\triangle_{99}$ | $\triangle_{100}$ | | $\triangle_{191}$ | $\triangle_{192}$ | → SOC$_{N+1}$ #41 |
| SOC$_N$ #2 → 22 | $\triangle_{97}$ | $\alpha_{98}$ | $\triangle_{99}$ | $\triangle_{100}$ | $\cdots$ | $\triangle_{191}$ | $\triangle_{192}$ | → SOC$_{N+1}$ #22 |
| SOC$_N$ #3 → 33 | $\triangle_{97}$ | $\triangle_{98}$ | $\alpha_{99}$ | $\triangle_{100}$ | | $\triangle_{191}$ | $\triangle_{192}$ | → SOC$_{N+1}$ #33 |
| 14 | $\triangle_{97}$ | $\triangle_{98}$ | $\triangle_{99}$ | $\alpha_{100}$ | | $\triangle_{191}$ | $\triangle_{192}$ | → SOC$_{N+1}$ #14 |
| $\vdots$ | $\vdots$ | | | | $\ddots$ | $\vdots$ | | $\vdots$ |
| SOC$_N$ #95 → 25 | $\triangle_{97}$ | $\triangle_{98}$ | $\triangle_{99}$ | $\triangle_{100}$ | | $\alpha_{191}$ | $\triangle_{192}$ | → SOC$_{N+1}$ #25 |
| SOC$_N$ #96 → 66 | $\triangle_{97}$ | $\triangle_{98}$ | $\triangle_{99}$ | $\triangle_{100}$ | $\cdots$ | $\triangle_{191}$ | $\alpha_{192}$ | → SOC$_{N+1}$ #66 |

EP 3 517 987 B1

# FIG. 5

/ 500

| Battery pack | | | |
|---|---|---|---|
| **Battery module 1** | **Battery module 1** | **Battery module 1** | **Battery module 1** |
| 1   6 | 11   16 | 21   26 | 31   36 |
| 2   7 | 12   17 | 22   27 | 32   37 |
| 3   8 | 13   18 | 23   28 | 33   38 |
| 4   9 | 14   19 | 24   29 | 34   39 |
| 5   10 | 15   20 | 25   30 | 35   40 |

## FIG. 6A

Battery module 1 ←——→ Battery model 1

Battery module 2 ←——→ Battery model 2

Battery module 3 ←——→ Battery model 3

Battery module 4 ←——→ Battery model 4

**FIG. 6B**

## FIG. 6C

## FIG. 6D

```
┌─────────────────────┐
│  Battery module 1   │◄──────►   Battery model 1
└─────────────────────┘
```

```
┌─────────────────────┐        ◄──────►  Battery model 2
│  Battery module 2   │
└─────────────────────┘        ◄──────►  Battery model 3
```

```
┌─────────────────────┐
│  Battery module 3   │◄──────►   Battery model 4
└─────────────────────┘
```

```
┌─────────────────────┐
│  Battery module 4   │◄──────►   Battery model 5
└─────────────────────┘
```

# FIG. 7A

Group 1

10 members ⟷ Battery model 1

Group 2

10 members ⟷ Battery model 2

Group 3

10 members ⟷ Battery model 3

Group 4

10 members ⟷ Battery model 4

## FIG. 7B

High SOC or voltage

Group 1

8 members ⟷ Battery model 1

Group 2

15 members ⟷ Battery model 2

Group 3

10 members ⟷ Battery model 3

Group 4

7 members ⟷ Battery model 4

Low SOC or voltage

# FIG. 7C

High SOC or voltage

Group 1

10 members ← → Battery model 1

← - - - → Battery model 4

Group 2

20 members ← → Battery model 2

Group 3

10 members ← → Battery model 3

Low SOC or voltage

**FIG. 8**

# FIG. 9A

# FIG. 9B

▨ : Battery model use period

State update period (N-th)

# FIG. 9C

State update period (N-th)

| Battery No. \ Switching period | ... | T28 | T29 | T30 | T31 | T32 | T33 | T34 | T35 | T36 | T37 | |
|---|---|---|---|---|---|---|---|---|---|---|---|---|
| 1 | ... | $\triangle_{28}$ | $\triangle_{29}$ | $\triangle_{30}$ | | | ... | | | $\triangle_{36}$ | $\alpha_{37}$ | $SOC_N$ #1 |
| 2 | ... | $\triangle_{28}$ | $\triangle_{29}$ | $\triangle_{30}$ | | | ... | | | $\alpha_{36}$ | $\triangle_{37}$ | $SOC_N$ #2 |
| ⋮ | ... | ⋮ | ⋮ | ⋮ | | | ... | | | ⋮ | ⋮ | ⋮ |
| 10 | ... | $\alpha_{28}$ | $\triangle_{29}$ | $\triangle_{30}$ | | | ... | | | $\triangle_{36}$ | $\triangle_{37}$ | $SOC_N$ #10 |
| 11 | ... | $\triangle_{28}$ | $\triangle_{29}$ | $\triangle_{30}$ | | | ... | | | $\triangle_{36}$ | $\beta_{37}$ | $SOC_N$ #11 |
| 12 | ... | $\triangle_{28}$ | $\triangle_{29}$ | $\triangle_{30}$ | | | ... | | | $\beta_{36}$ | $\triangle_{37}$ | $SOC_N$ #12 |
| ⋮ | ... | ⋮ | ⋮ | ⋮ | | | ... | | | ⋮ | ⋮ | ⋮ |
| 20 | ... | $\beta_{28}$ | $\triangle_{29}$ | $\triangle_{30}$ | | | ... | | | $\triangle_{36}$ | $\triangle_{37}$ | $SOC_N$ #20 |
| 21 | ... | $\triangle_{28}$ | $\triangle_{29}$ | $\triangle_{30}$ | | | ... | | | $\triangle_{36}$ | $\gamma_{37}$ | $SOC_N$ #21 |
| 22 | ... | $\triangle_{28}$ | $\triangle_{29}$ | $\triangle_{30}$ | | | ... | | | $\gamma_{36}$ | $\triangle_{37}$ | $SOC_N$ #22 |
| ⋮ | ... | ⋮ | ⋮ | ⋮ | | | ... | | | ⋮ | ⋮ | ⋮ |
| 30 | ... | $\gamma_{28}$ | $\triangle_{29}$ | $\triangle_{30}$ | | | ... | | | $\triangle_{36}$ | $\triangle_{37}$ | $SOC_N$ #30 |
| 31 | ... | $\triangle_{28}$ | $\triangle_{29}$ | $\triangle_{30}$ | | | ... | | | $\triangle_{36}$ | $\delta_{37}$ | $SOC_N$ #31 |
| 32 | ... | $\triangle_{28}$ | $\triangle_{29}$ | $\triangle_{30}$ | | | ... | | | $\delta_{36}$ | $\triangle_{37}$ | $SOC_N$ #32 |
| ⋮ | ... | ⋮ | ⋮ | ⋮ | | | ... | | | ⋮ | ⋮ | ⋮ |
| 40 | ... | $\delta_{28}$ | $\triangle_{29}$ | $\triangle_{30}$ | | | ... | | | $\triangle_{36}$ | $\triangle_{37}$ | $SOC_N$ #40 |

Group 1: Battery No. 1–10
Group 2: Battery No. 11–20
Group 3: Battery No. 21–30
Group 4: Battery No. 31–40

# FIG. 10A

# FIG. 10B

▨ : Battery model use period

State update period (N-th)

• • •

| Switching period / Battery No. | T19 | T20 | T21 | T22 | T23 | T24 | T25 | T26 | T27 | T28 | T29 | T30 | T31 | T32 | T33 | T34 | T35 | T36 | T37 | |
|---|---|---|---|---|---|---|---|---|---|---|---|---|---|---|---|---|---|---|---|---|
| 1 | ▨ | | | | | | | | | | | | | | | | | | ▨ | Group 1 |
| 2 | | ▨ | | | | | | | | | | | | | | | | ▨ | | |
| 3 | | | ▨ | | | | | | | | | | | | | | ▨ | | | |
| 4 | | | | ▨ | | | | | | | | | | | | ▨ | | | | |
| 5 | | | | | ▨ | | | | | | | | | | ▨ | | | | | |
| 6 | | | | | | ▨ | | | | | | | | ▨ | | | | | | |
| 7 | | | | | | | ▨ | | | | | | ▨ | | | | | | | |
| 8 | | | | | | | | ▨ | | | | ▨ | | | | | | | | |
| 9 | | | | | | | | | ▨ | | ▨ | | | | | | | | | |
| 10 | | | | | | | | | | ▨ | | | | | | | | | | |
| 11 | | | | | | | | | | | | | | | | | | | | Group 2 |
| 12 | | | | | | | | | | | | | | | | | | | | |
| 13 | | | | | | | | | | | | | | | | | | | ▨ | |
| 14 | | | | | | | | | | | | | | | | | | ▨ | | |
| 15 | | | | | | | | | | | | | | | | | ▨ | | | |
| 16 | | | | | | | | | | | | | | | | ▨ | | | | |
| 17 | | | | | | | | | | | | | | | ▨ | | | | | |
| 18 | | | | | | | | | | | | | | ▨ | | | | | | |
| 19 | | | | | | | | | | | | | ▨ | | | | | | | |
| 20 | | | | | | | | | | | | ▨ | | | | | | | | |
| 21 | | | | | | | | | | | ▨ | | | | | | | | | |
| 22 | | | | | | | | | | ▨ | | | | | | | | | | |
| 23 | | | | | | | | | ▨ | | | | | | | | | | | |
| 24 | | | | | | | | ▨ | | | | | | | | | | | | |
| 25 | | | | | | | ▨ | | | | | | | | | | | | | |
| 26 | | | | | | ▨ | | | | | | | | | | | | | | |
| 27 | | | | | ▨ | | | | | | | | | | | | | | | |
| 28 | | | | ▨ | | | | | | | | | | | | | | | | |
| 29 | ▨ | | ▨ | | | | | | | | | | | | | | | | | |
| 30 | | ▨ | | | | | | | | | | | | | | | | | | |
| 31 | ▨ | | | | | | | | | | | | | | | | | | ▨ | Group 3 |
| 32 | | ▨ | | | | | | | | | | | | | | | | ▨ | | |
| 33 | | | ▨ | | | | | | | | | | | | | | ▨ | | | |
| 34 | | | | ▨ | | | | | | | | | | | | ▨ | | | | |
| 35 | | | | | ▨ | | | | | | | | | | ▨ | | | | | |
| 36 | | | | | | ▨ | | | | | | | | ▨ | | | | | | |
| 37 | | | | | | | ▨ | | | | | | ▨ | | | | | | | |
| 38 | | | | | | | | ▨ | | | | ▨ | | | | | | | | |
| 39 | | | | | | | | | ▨ | | ▨ | | | | | | | | | |
| 40 | | | | | | | | | | ▨ | | | | | | | | | | |

# FIG. 11A

Group update period (first)

| Order update period (first) | | | | Order update period (N-th) | | | |
|---|---|---|---|---|---|---|---|
| $T_1$ | $T_1$ | ••• | $T_N$ | $T_1$ | $T_1$ | ••• | $T_N$ |

•••

•••

## FIG. 11B

| Travel distance | |
|---|---|
| ~500km | Group update period (first) |
| 500~700km | Group update period (second) |
| 700~900km | Group update period (third) |
| ⋮ | ⋮ |

## FIG. 11C

| SOH | |
|---|---|
| 1~0.95 | Group update period (first) |
| 0.95~0.93 | Group update period (second) |
| 0.93~0.91 | Group update period (third) |

$$\vdots \qquad\qquad \vdots$$

FIG. 12

# FIG. 13

```
            ┌─────────┐
            │  Start  │
            └────┬────┘
                 │                                                  1310
                 ▼
┌────────────────────────────────────────────────────────────────────┐
│     Determine state information of batteries in each of switching periods │
│              1311                                          1312         │
│  ┌────────────────────────────┐  ┌────────────────────────────┐        │
│  │    Determine state information │  │   Determine state information  │        │
│  │ of target battery in each switching │  │  of non-target battery in each │        │
│  │  period based on battery model │  │ switching period based on state │        │
│  │ and sensing data of target battery │  │  variation of non-target battery │        │
│  │     in each switching period   │  │     in each switching period   │        │
│  └────────────────────────────┘  └────────────────────────────┘        │
└────────────────────────────────────────────────────────────────────┘
                 │                                                  1320
                 ▼
┌────────────────────────────────────────────────────────────────────┐
│              Output state information of batteries                    │
│         in last switching period of switching periods                │
└────────────────────────────────────────────────────────────────────┘
                 │
                 ▼
            ┌─────────┐
            │   End   │
            └─────────┘
```

# FIG. 14

**EP 3 517 987 B1**

**REFERENCES CITED IN THE DESCRIPTION**

**Patent documents cited in the description**

- US 2017045587 A1

- EP 3499257 A1